(19) Europäisches Patentamt
European Patent Office
Office européen des brevets

(11) **EP 1 067 437 B1**

(12) **EUROPÄISCHE PATENTSCHRIFT**

(45) Veröffentlichungstag und Bekanntmachung des Hinweises auf die Patenterteilung:
**07.03.2007 Patentblatt 2007/10**

(51) Int Cl.:
***G03F 7/20*** *(2006.01)*

(21) Anmeldenummer: **00112858.6**

(22) Anmeldetag: **17.06.2000**

(54) **Beleuchtungssystem mit anamorphotischen Komponenten zur Erhöhung des Bildfeldaspektverhältnisses**

Illumination system with anamorphic components for enlarging the image field aspect ratio

Système d'illumination avec composants anamorphoseurs pour l'augmentation d'un rapport largeur/hauteur du champ d'image

(84) Benannte Vertragsstaaten:
**DE FR GB IT NL**

(30) Priorität: **09.07.1999 DE 19931848**

(43) Veröffentlichungstag der Anmeldung:
**10.01.2001 Patentblatt 2001/02**

(73) Patentinhaber: **Carl Zeiss SMT AG**
**73446 Oberkochen (DE)**

(72) Erfinder: **Schultz, Jörg**
**73430 Aalen (DE)**

(74) Vertreter: **Sawodny, Michael-Wolfgang**
**Adolf - Lüken - Höflich - Sawodny,**
**Dreiköniggasse 10**
**89073 Ulm (DE)**

(56) Entgegenhaltungen:
**EP-A- 0 668 541      GB-A- 2 217 036**
**US-A- 5 594 526      US-A- 5 844 727**

**Beschreibung**

Die Erfindung betrifft ein Beleuchtungssystem, insbesondere ein solches für die Lithographie also beispielsweise VUV und EUV-Lithographie mit Wellenlängen ≤ 193nm, welches ein Feld mit einem Aspektverhältnis, das nicht gleich 1:1 ist, beleuchtet, wobei das Beleuchtungssystem wenigstens eine Lichtquelle, einen Feldspiegel oder eine Feldlinse sowie optische Komponenten zur Transformierung der Lichtquelle in sekundäre Lichtquellen umfasst.

Um die Strukturbreiten für elektronische Bauteile noch weiter reduzieren zu können, insbesondere in den Submikron-Bereich, ist es erforderlich, die Wellenlänge des für die Mikrolithographie eingesetzten Lichtes zu verringern.

Denkbar ist bei Wellenlängen ≤ als 193 nm, beispielsweise die Lithographie mit weichen Röntgenstrahlen wie sie aus der US 5339346 bekannt geworden ist.

Neben der Beleuchtung gemäß der US 5339346, die mindestens vier paarweise symmetrisch zur Quelle angeordnete Spiegelfacetten benötigt, kann man Beleuchtungssysteme vorsehen, die beispielsweise mit Hilfe von reflektiven Wabenplatten zur homogenen Beleuchtung des Ringfeldes eines Belichtungsobjektives arbeiten. Solche Systeme haben den Vorteil, dass das Feld eines Objektives mit möglichst wenigen Reflektionen homogen beleuchtet wird, des Weiteren eine feldunabhängige Ausleuchtung der Pupille bis zu einem bestimmten Füllgrad gewährleistet ist.

Reflektive Wabenplatten für EUV-Beleuchtungssysteme sind aus der US 5 581 605 bekannt geworden.

Aus der EP 0 668 541A1 und der US 5 844 727 sind refraktive Beleuchtungssysteme bzw. Projektionsbelichtungsanlagen bekannt geworden, die Zylinderlinsen umfassen.

Gemäß der EP 0 668 541 wird mittels eines Kondensers umfassend eine Zylinderlinse eine Ausleuchtung zur Verfügung gestellt, bei der die sekundären Lichtquellen in einer zx-Ebene entfernt von einer Pupillenebene zu Liegen kommen.

Als Lichtquellen für EUV-Beleuchtungssysteme werden derzeit diskutiert.

Laser-Plasma-Quellen
Pinch-Plasma-Quellen
Synchrotron-Strahlungsquellen

Bei Laser-Plasma-Quellen wird ein intensiver Laserstrahl auf ein Target (Festkörper, Gasjet, Tröpfchen) fokussiert. Durch die Anregung wird das Target so stark erhitzt, dass ein Plasma entsteht. Dieses emittiert EUV-Strahlung.

Typische Laser-Plasma-Quellen weisen eine kugelförmige Abstrahlung auf, d. h. einen Abstrahlwinkelbereicht von $4 \pi$ sowie einen Durchmesser von 50 $\mu$m - 200 $\mu$m.

Bei Pinch-Plasma-Quellen wird das Plasma über elektrische Anregung erzeugt.

Pinch-Plasma-Quellen lassen sich als Volumenstrahler (ø = 1.00 mm) beschrieben, die in $4 \pi$ abstrahlen, wobei die Abstrahlcharakteristik durch die Quellgeometrie gegeben ist.

Bei Synchronstrahlungsquellen kann man derzeit drei Arten von Quellen unterscheiden:

- Bending-Magneten
- Wiggler
- Undulatoren

Bei Bending-Magnet-Quellen werden die Elektronen durch einen Bending-Magneten abgelenkt und Photonen-Strahlung emittiert.

Wiggler-Quellen umfassen zur Ablenkung des Elektrons bzw. eines Elektronenstrahles einen sogenannten Wiggler, der eine Vielzahl von aneinandergereihten abwechselnd gepolten Magnetpaaren umfaßt. Durchläuft ein Elektron einen Wiggler, so wird das Elektron einem periodischen, vertikalen Magnetfeld ausgesetzt; das Elektron oszilliert dementsprechend in der horizontalen Ebene. Wiggler zeichnen sich weiter dadurch aus, daß keine Kohärenzeffekte auftreten. Die mittels eines Wigglers erzeugte Synchrotronstrahlung ähnelt der eines Bending-Magneten und strahlt in einen horizontalen Raumwinkel ab. Sie weist im Gegensatz zum Bending-Magneten einen um die Anzahl der Pole des Wigglers verstärkten Fluß auf.

Der Übergang von Wiggler-Quellen zu Undulator-Quellen ist fließend.

Bei Undulator-Quellen werden die Elektronen im Undulator einem Magnetfeld mit kürzerer Periode und geringerem Magnetfeld der Ablenkpole als beim Wiggler ausgesetzt, so daß Interferenz-Effekte der Synchrotronstrahlung auftreten. Die Synchrotronstrahlung weist aufgrund der Interferenzeffekte ein diskontinuierliches Spektrum auf und strahlt sowohl horizontal wie vertikal in ein kleines Raumwinkelelement ab; d.h. die Strahlung ist stark gerichtet.

Da Ausdehnung und Winkelspektrum der derzeit diskutierten EUV-Lichtquellen nicht ausreichen, um Feld und Apertur in der Retikelebene einer Lithographie-Projektions-Belichtungsanlage zu füllen bzw. zu beleuchten, umfassen die derzeit diskutierten Beleuchtungssysteme mindestens einen Spiegel oder eine Linse mit Rasterelementen zur Erzeugung einer Vielzahl von sekundären Lichtquellen, die in der Blendenebene gleichmäßig verteilt sind. Da die geometrische Ausdehnung der Rasterelemente des ersten Spiegels oder der ersten Linse die Form des ausgeleuchteten Feldes in der Retikelebene bestimmt, werden die Rasterelemente des ersten Spiegels oder der ersten Linse bei einem ringförmigen Scan-Schlitz bevorzugt rechteckig ausgebildet, wenn das zu beleuchtende Feld rechteckig ist oder ein Segment eines Ringfeldes darstellt. Die optische Wirkung der Rasterelemente des ersten Spiegels oder der ersten Linse, die im nachfolgendem auch als Feldwaben bezeichnet werden, ist so ausgelegt, daß in der Blendenebene Bilder der Lichtquelle entstehen, sogenannte sekundäre Lichtquellen. Ein EUV-Beleuchtungssystem, bei dem mit Hilfe zweier senkrecht zueinander angeordneter eindimensionaler Arrays von Zylinderspiegeln eine Vielzahl sekundärer Lichtquellen in einer Ebene ausgebildet werden, ist bespielsweise aus der US 5 677 939 bekanntgeworden. Nachteilig an dieser Anordnung ist, daß zwei Arrays von Zylinderspiegeln notwendig sind, um ein Feld mit großem Aspektverhältnis und die Austrittspupille des Beleuchtungssystems auszuleuchten.

In einem zweiten Ausführungsbeispiel wird in der US 5 677 939 ein System gezeigt, bei dem mit Hilfe eines eindimensionalen Arrays von Zylinderspiegeln eine kritische köhlersche Beleuchtung realisiert wird. Nachteilig hieran ist, daß die Austrittspupille des Beleuchtungssystems strichförmig und damit ungleichmäßig beleuchtet wird.

Ist die Ausdehnung der Lichtquelle gering, beispielsweise näherungsweise punktförmig, wie bei einer Undulator-Quelle, so ist auch die Ausdehnung der sekundären Lichtquelle gering, und alle Lichtstrahlen laufen nahezu durch einen Punkt. In jeder Ebene nach der Blendenebene entsteht dann ein Bild der Feldwabe, wobei der Abbildungsmaßstab durch das Verhältnis von Abstand Blende - Retikel zu Feldwabe - Blende gegeben ist. Die Feldwaben sind dabei so gekippt, daß sich die Bilder der Feldwaben in der Retikelebene zumindest zum Teil überlagern.

Die Kantenbreite, also der Abstand von 0%-Punkt und 100%-Punkt der Intensität des Bildes der Feldwaben, ist bei Punktlichtquellen nahezu Null, d.h. die Intensität fällt bei idealer Abbildung von 100 % direkt auf 0 % ab.

Bei ausgedehnten Lichtquellen sind auch die sekundären Lichtquellen ausgedehnt, so daß das Bild der Feldwaben in der Retikelebene unscharf wird. Die Kantenbreite des Bildes der Feldwaben nimmt zu.

Will man eine Überleuchtung der vorgegebenen Breite des auszuleuchtenden Feldes verhindern, so kann dies dadurch erreicht werden, daß die Höhe der Feldwaben reduziert wird.

Derart ausgestaltete Feldwaben weisen ein hohes Aspektverhältnis auf.

Feldwaben mit hohem Aspektverhältnis sind auch dadurch bedingt, daß das auszuleuchtende Feld ein großes Aspektverhältnis, beispielsweise ein x-y-Seitenverhältnis von 17,5:1 aufweist.

Feldwaben mit einem hohen Aspektverhältnis sind jedoch auf einer Feldwabenplatte nur ungünstig zu verteilen und fertigungstechnisch aufwendig.

Aufgabe der Erfindung ist es somit, ein Beleuchtungssystem, insbesondere für die EUV-Lithographie, anzugeben, das einen einfachen Aufbau aufweist und bei dem die Nachteile des Standes der Technik vermieden werden können, wobei das auszuleuchtende Feld ein Aspektverhältnis $\neq$ 1:1 aufweist.

Erfindungsgemäß wird die Aufgabe durch ein Beleuchtungssystem mit den Merkmalen des Anspruchs 1, eine EUV-Projektionsbelichtungsanlage mit den Merkmalen des Anspruchs 36 und ein Verfahren mit den Merkmalen des Anspruchs 38 gelöst.

Die tangentialen sekundären Lichtquellen werden über ein in der y-z-Ebene verlaufendes Strahlenbüschel gebildet, die sagittalen sekundären Lichtquellen über ein in der x-z-Ebene verlaufendes Strahlenbüschel. Als x-Richtung wird die Richtung der größeren Ausdehnung des auszuleuchtenden Feldes, als y-Richtung die Richtung der geringeren Ausdehnung des auszuleuchtenden Feldes in der nachfolgenden Beschreibung und als z-Richtung, die sowohl auf der x-Richtung wie auch der y-Richtung senkrecht stehende Richtung bezeichnet. Die y-Richtung ist vorliegend bei einem Scan-Lithographiesystem auch die Scan-Richtung, die x-Richtung die Richtung senkrecht zur Scan-Richtung.

Die optischen Komponenten zur Transformation der Lichtquelle in sekundäre Lichtquellen umfassen wenigstens einen Spiegel oder eine Linse, der bzw. die in Rasterelemente gegliedert ist, wobei die Rasterelemente eine zweidimensionale Anordnung aufweisen. Hierdurch kann eine sehr regelmäßige Ausleuchtung der Austrittspupille erreicht werden.

Zum Ausleuchten des Spiegels bzw. der Platte mit Rasterelementen kommt eine Kollektoreinheit zum Einsatz, die an die jeweilige Quelle angepaßt ist.

Bevorzugt sind die auf dem ersten Spiegel bzw. Linse zweidimensional angeordneten Rasterelemente in einzelne Zeilen untergliedert, wobei jede Zeile mehrere nebeneinanderliegende Rasterelemente umfaßt. Die einzelnen Zeilen wiederum sind gegeneinander verschoben, was zu einer gleichmäßigeren Ausleuchtung der Austrittspupille führt.

Eine erste Ausführungsform der Erfindung sieht vor, daß die Rasterelemente des Spiegels oder der Linse zur Erzeugung von sagittalen und tangentialen sekundärer Lichtquellen derart geformt sind, daß jedes Rasterelement eine anamorphotische Wirkung aufweist, beispielsweise indem die Rasterelemente des ersten Spiegels zylinderförmig oder toroidförmig ausgebildet sind.

In einer besonderen Ausgestaltung der Erfindung ist vorgesehen, daß die Kollektoreinheit eine anamorphische Wirkung besitzt und damit die Lichtquelle in eine sekundäre Lichtquelle abbildet, die in eine tangentiale und sagittale Lichtquelle aufgespalten ist.

Handelt es sich bei dem auszuleuchtenden Feld um ein solches in Rechteckform oder ein Ringsegment, so werden die Rasterelemente vorteilhafterweise rechteckförmig ausgestaltet. Da die Rasterelemente in die Feldebene abgebildet werden, werden sie auch als Feldwaben bezeichnet.

Bei einer Ausführungsform mit sehr großen Aspektverhältnissen des auszuleuchtenden Feldes, beispielsweise einem x-y-Seitenverhältnis von 17,5:1, 13:1 oder 2:1 ist mit Vorteil vorgesehen, daß das Aspektverhältnis der zylinder- bzw. toroidförmigen Feldwaben kleiner ist. Bei einem x-y-Seitenverhältnis des auszuleuchtenden Feldes von 17,5:1 oder 13:1 kann das Aspektverhältnis der Feldwaben beispielsweise 4:1 sein; bei einem x-y-Seitenverhältnis des auszuleuchtenden Feldes von 2:1 beispielsweise 1,5:1.

Mit Vorteil ist vorgesehen, in Abhängigkeit der im Beleuchtungssystem eingesetzten Feldspiegel bzw. Feldlinse (n) die Feldwaben auf dem ersten Spiegel bzw. der Linse derart anzuordnen, daß die von den Feldspiegeln der Feldlinse (n) erzeugten Bilder der sekundären Lichtquellen, die im folgenden als "Teilpupillen" bezeichnet werden, in der Austrittspupille des Beleuchtungssystems weitgehend gleichmäßig verteilt sind.

Hierzu wird zunächst die Rasterung der Teilpupillen in der Austrittspupille des Beleuchtungssystems vorgegeben. Anschließend wird die Lage der Feldwaben auf der Feldwabenplatte bestimmt, indem man die Schwerstrahlen der Teilpupillen durch die Feldlinse bzw. Feldlinsen hindurch bis zur Ebene, die durch die Feldwabenplatte definiert ist, berechnet. Die Richtung der Schwerstrahlen ist so vorgegeben, daß sie die Retikelebene in der Mitte schneiden, Ihr Durchstoßpunkt auf der Feldwabenplatte bestimmt die Position der Feldwaben. Bei dieser Art der Bestimmung der Position der Feldwaben ist die Nebenbedingung einzuhalten, daß der Abstand der Teilpupillen in der vorgegebenen Rasterung so gewählt wird, daß sich die Feldwaben nicht überlappen.

Aufgrund optischer Abbildungsfehler der Feldlinsenabbildung, z.B. Verzeichnung, werden die Feldwaben unsymmetrisch auf der Feldwabenplatte angeordnet sein.

Um den durch die unsymmetrische Anordnung der Waben hervorgerufenen Intensitäts-Tilt in der Pupillenausleuchtung zu kompensieren, ist mit Vorteil vorgesehen, die Reflektivitäten der Waben entsprechend anzupassen.

Möglich ist auch, die Kollektoreinheit entsprechend anzupassen.

Um bei Systemen mit ausgedehnten Lichtquellen ein scharfes Bild der Feldwaben in der Retikelebene zu erhalten, kann man mit Vorteil einen zweiten Spiegel oder eine Linse mit Rasterelementen, d.h. eine sogenannte Doppelfacettierung, vorsehen, wobei die Rasterelemente des zweiten Spiegels oder der zweiten Linse die sogenannten Pupillenwaben, am Ort der sekundären Lichtquellen sitzen.

Bei Systemen mit zwei Spiegeln mit Rasterelementen ist die Form der Rasterelemente des zweiten Spiegels, d.h. der Pupillenwaben, vorteilhafter Weise der Form der sekundären Lichtquellen angepaßt und somit verschieden von der Form der ersten Rasterelemente, d.h. der Feldwaben. Beispielsweise können die Pupillenwaben rund ausgebildet sein, wenn auch die Lichtquelle rund ausgebildet ist. Ob Pupillenwaben erforderlich sind, hängt von der Auslegung der Feldwaben und der Ausdehnung und dem Winkelspektrum der Lichtquelle ab. Das Produkt von Ausdehnung und Winkelspektrum bzw. das Produkt von Feld und Apertur wird als Lichtleitwert bezeichnet.

Der tangentiale Lichtleitwert berücksichtigt nur Strahlen, die in der y-z-Ebene verlaufen. Der zweidimensionale Lichtleitwert berücksichtigt alle Strahlen.

Je nach Art der Lichtquelle unterscheidet man die nachfolgenden Fälle:

1. Tangentialer Lichtleitwert der Quelle << tangentialer Lichtleitwert des auszuleuchtenden Feldes, d.h. Kantenbreite << y-Feldausdehnung. Ein Beleuchtungssystem ohne Pupillenwaben ist möglich.

2. Tangentialer Lichtleitwert der Quelle = tangentialer Lichtleitwert des auszuleuchtenden Feldes, d.h. Kantenbreite = y-Feldausdehnung. Ein Design ohne Pupillenwaben ist möglich, wenn Komponenten mit anamorphotischer Wirkung verwendet werden. Die Beleuchtung ist in der y-Richtung kritisch, in x-Richtung köhlersch. Um die x-Richtung randscharf abzubilden, können in einer weitergebildeten Ausführungsform am Ort der sagittalen Lichtquellen zylinder- oder toroidförmige Rasterelemente als Pupillenwaben eingesetzt werden.

3. Zweidimensionaler Lichtleitwert der Quelle $\leq$ zweidimensionaler Lichtleitwert des auszuleuchtenden Feldes und tangentialer Lichtleitwert der Quelle > tangentialer Lichtleitwert des Feldes. In diesem Fall ist es erforderlich, zur korrekten Ausleuchtung des Feldes Pupillenwaben vorzusehen.

Für eine Anwendung des Beleuchtungssystems in einem Scan-Lithographiesystem ist es nicht unbedingt erforderlich, die schmale Seite einer Feldwabe, d.h. die y-Richtung randscharf abzubilden. Wichtig ist, daß das ausgeleuchtete Feld innerhalb des vom nachfolgenden Projektionsobjektivs definierten Ringfeld liegt.

Solange dies bei ausgedehnten Lichtquellen mit der Verringerung der Feldwabenbreite oder mit dem Einsatz von Feldwaben mit anamorphotischer Wirkung (bis hin zur kritischen Beleuchtung der schmalen Feldseite) erreicht werden kann, ist es nicht notwendig, für die y-Richtung Pupillenwaben vorzusehen.

Übersteigt die Feldausleuchtung selbst bei kritischer Beleuchtung die maximal mögliche Feldbreite in y-Richtung, so sind Pupillenwaben für die y-Richtung erforderlich.

Senkrecht zur Scanrichtung, d.h. in x-Richtung, soll das beleuchtete Feld scharf berandet sein, da andernfalls mit zusätzlichen Maskierungseinrichtungen das beleuchtete Feld senkrecht zur Scanrichtung, d.h. in x-Richtung, begrenzt werden muß, was aufgrund der Vignettierung des beleuchteten Feldes zu Lichtverlust führt. Bei ausgedehnten Lichtquellen werden daher vorteilhafter Weise für die x-Richtung Pupillenwaben vorgesehen.

Welche Art von Pupillenwaben zum Einsatz kommen, hängt davon ab, welche Anforderungen an die Feldausleuchtung gestellt werden.

Soll nur das ausgeleuchtete Feld in x-Richtung scharf berandet sein, also die Feldwaben in x-Richtung scharf in die Retikelebene abgebildet werden, so kommen zylinderförmige Pupillenwaben am Ort der sagittalen sekundären Lichtquellen zum Einsatz. Die Zylinder sind dabei in Richtung der linienförmigen sagittalen sekundären Lichtquellen orientiert und bilden die lange Feldwabenseite in die Retikelebene ab.

Soll auch die Abbildung in y-Richtung beeinflußt werden, so kommen toroidförmige Pupillenwaben zum Einsatz. Sie bilden die lange Feldwabenseite in die Retikelebene ab und begrenzen die Ausleuchtung in y-Richtung auf den zulässigen Bereich. Sie sind entweder am Ort der sagittalen sekundären Lichtquellen oder zwischen sagittalen und tangentialen Lichtquellen angeordnet. Bei einer Anordnung zwischen sagittalen und tangentialen Lichtquellen muß die Feldwabenabbildung und die Wabenabmessungen in x-Richtung entsprechend angepaßt werden.

Feld- und Pupillenwaben werden so angeordnet und ausgerichtet, daß zwischen jeweils einer Feld- und einer Pupillenwabe ein Lichtweg hergestellt wird; die Überlagerung der Bilder der Feldwaben in der Retikelebene erreicht wird und die Teilpupillen in der Austrittspupille des Beleuchtungssystems weitgehend gleichmäßig verteilt sind. Bezüglich des Verfahrens zur Anordnung der Feld- und Pupillenwaben wird auf die US 6 198 793 und entsprechende EP 0 955 641 A1 mit dem Titel "Illumination system, particularly for EUV-Lithography", der Anmelderin verwiesen.

Vorteilhafterweise sind die Feldspiegel oder Feldlinse(n) des erfindungsgemäßen Beleuchtungssystems derart ausgebildet, daß die Blendenebene in die Austrittspupille des Beleuchtungssystems abgebildet wird.

Durch die erfindungsgemäße Aufspaltung sekundärer Lichtquellen in tangentiale und sagittale sekundäre Lichtquellen können nachfolgende Vorteile erzielt werden; selbstverständlich auch in Kombination:

1. Reduzieren des Wabenaspektverhältnisses durch optische Komponenten mit anamorphotischer Wirkung.

Bei einer Punktlichtquelle können die Feldwaben selbst bei einem Wabenaspektverhältnis, das im Vergleich zum Feldaspektverhältnis reduziert ist, mit minimaler Kantenbreite in die Bildebene abgebildet werden, wobei die anamorphotische Wirkung entsprechend ausgelegt werden muß.

2. Ausleuchtung des Feldes bei ausgedehnten Lichtquellen.

Bei ausgedehnten Lichtquellen kann die Kantenbreite, die sich ohne Pupillenwaben ergibt, derart berücksichtigt werden, daß die tangentiale Lichtquelle im Vergleich zu einer Punktlichtquelle Richtung Bildebene verschoben wird. Dies ist über eine Verringerung der y-Brechkraft der Feldwabe mit anamorphotischer Wirkung möglich. Dadurch wird die y-Breite des Bildes der Feldwabe reduziert. Den Grenzfall stellt die kritische Beleuchtung in y-Richtung dar, bei der sich die tangentiale Lichtquelle in der Retikelebene befindet. Die Quelle wird also in y-Richtung in die Bildebene abgebildet. Die y-Ausdehnung des Bildes der Lichtquelle sollte dabei die y-Breite des ausgeleuchteten Feldes nicht überschreiten. Ansonsten muß das ausgeleuchtete Feld maskiert oder Pupillenwaben eingesetzt werden.

Die Erfindung soll nachfolgend anhand der Abbildungen beispielhaft beschrieben werden.

Es zeigen:

Fig. 1 den Verlauf der Lichtstrahlen einer Feldwabe, die in der Geometrie der auszuleuchtenden Fläche entspricht und die plan ausgebildet ist.

Fig. 2 die Lichtstrahlen einer zylinderförmigen Wabe mit anamorphotischer Wirkung.

Fig. 3 die Lichtquellen einer zylinderförmigen Wabe mit anamorphotischer Wirkung, wobei der Grenzfall der kritischen Beleuchtung in y-Richtung dargestellt ist, bei der sich die tangentiale Lichtquelle in der Retikelebene befindet.

Fig. 4 den y-Schnitt durch ein System mit Lichtquelle, Kollektorspiegel, Zylinderwabenplatte.

Fig. 5 den x-Schnitt durch das System gemäß Fig. 4 mit Lichtquelle, Kollektorspiegel, Zylinderwabenplatte.

Fig. 6 den y-Schnitt durch ein System mit Lichtquelle, Kollektorspiegel, Zylinderwabenplatte, wobei der Grenzfall der kritischen Beleuchtung in y-Richtung dargestellt ist, bei der sich die tangentiale Lichtquelle in der Retikelebene befindet.

Fig. 7 den x-Schnitt durch ein System gemäß Fig. 6.

Fig. 8    das sagittale Strahlenbündel eines Systems mit Lichtquelle, Kollektorspiegel, zentraler quadratischer Zylinderwabe.

Fig. 9    das tangentiale Strahlenbündel eines Systems gemäß Fig. 8.

Fig. 10, 11    die Ausleuchtung des Rechteckfeldes in der vorläufigen Bildebene einer Anordnung gemäß Fig. 8.

Fig. 12    die Pupillenausleuchtung in der Feldmitte eines Systems gemäß Fig. 8.

Fig. 13    das sagittale Strahlenbündel eines Systems Quelle, Kollektorspiegel, zentrale Zylinderwabe mit einem Seitenverhältnis 4:1.

Fig. 14    das tangentiale Strahlenbündel eines Systems gemäß Fig. 13.

Fig. 15, 16    die Ausleuchtung des Rechteckfeldes eines Systems gemäß Fig. 13.

Fig. 17    die Pupillenausleuchtung in der Feldmitte eines Systems gemäß Fig. 13.

Fig. 18    den Verlauf der Randstrahlen mit NA = 0,025 einer Ausgestaltung mit Aspektverhältnis 4:1 eines rückwärts gerechneten Systems.

Fig. 19    Strahldurchstoßpunkte eines rückwärts gerechneten Strahlgitters in der Wabenebene in einer Ausgestaltung der Erfindung gemäß Fig. 18.

Fig. 20    die Pupillenausleuchtung eines Systems mit gleichmäßiger Verteilung der Feldwaben.

Fig. 21    die Pupillenausleuchtung eines Systems mit ungleichmäßiger Verteilung der Feldwaben.

Fig. 22    die Verteilung der 4:1 Waben auf einer Feldwabenplatte, die zu einer Pupillenausleuchtung gemäß Fig. 21 führen.

Fig. 23    die Randstrahlen vom Retikel bis zur Eintrittspupille eines Systems Lichtquelle, Kollektor, Zylinderwabenplatte, Feldlinse, Eintrittspupille des Abbildungsobjektives.

Fig. 24    den Verlauf der Sagittalstrahlen für ein System gemäß Fig. 23.

Fig. 25    den Verlauf der Tangentialstrahlen für ein System gemäß Fig. 23.

Fig. 26    die Ausleuchtung des Retikels mit einem Beleuchtungssystem gemäß Fig. 23.

Fig. 27    Intensitätsschnitte parallel zur y-Achse eines Systems gemäß Fig. 23 für eine 50 $\mu$m-Quelle.

Fig. 28    die integrale Scanenergie eines Systems gemäß Fig. 20.

Fig. 29    Intensitätsschnitte parallel zur y-Achse eines Systems gemäß Fig. 23 mit einer 100 $\mu$m-Lichtquelle mit köhlerscher Beleuchtung und Planfacetten als Feldwaben mit Aspektverhältnis 17,5:1.

Fig. 30    Intensitätsschnitte parallel zur y-Achse eines Systems gemäß Fig. 23 mit einer 100 $\mu$m-Lichtquelle mit kritisch köhlerscher Beleuchtung und Zylinderwaben als Feldwaben mit Aspektverhältnis 17,5:1.

Fig. 31    die Pupillenausleuchtung eines Systems gemäß Fig. 30.

Fig. 32    Intensitätsschnitte parallel zur y-Achse eines Systems gemäß Fig. 23 mit einer 100 $\mu$m-Lichtquelle mit kritisch köhlerscher Beleuchtung und Zylinderwaben als Feldwaben mit Aspektverhältnis 4:1.

Fig. 33    die Pupillenausleuchtung eines Systems gemäß Fig. 32.

Fig. 34, 35    die Ausleuchtung eines Rechteckfeldes in der vorläufigen Bildebene eines Systems mit astigmatischem Kollektorspiegel und Planfacetten-Wabenkondensor bzw. Planfacetten-Wabenplatte.

Fig. 36      die Pupillenausleuchtung eines Systems gemäß den Figuren 34 bis 35 in der Feldmitte.

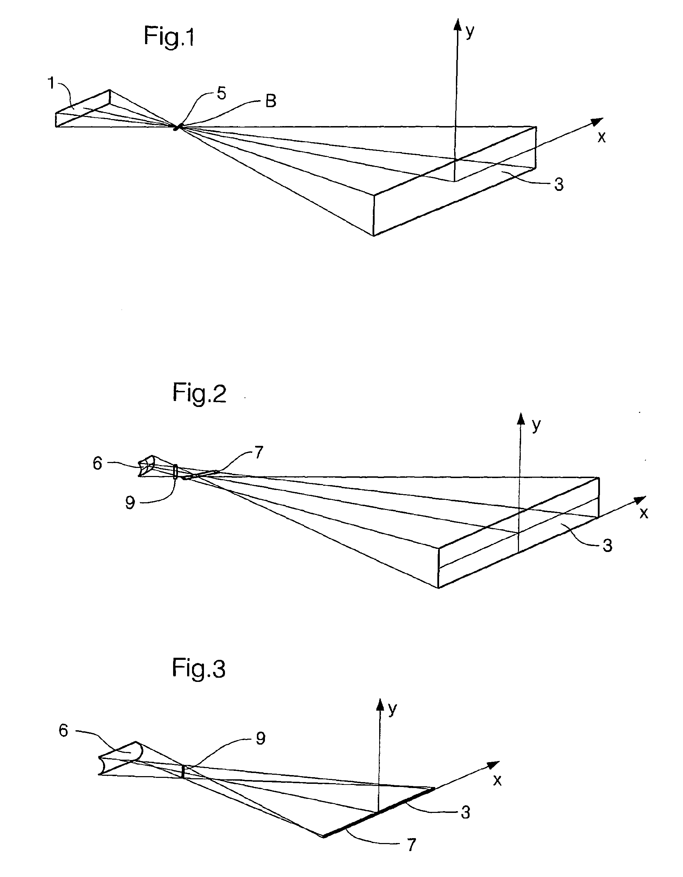

In Figur 1 ist der Lichtverlauf von einer Feldwabe 1, deren Wabenform der Feldausdehnung entspricht, zur Bildebene 3, die vorliegend mit dem Retikel 3 zusammenfällt, gezeigt. Die Feldwabe fokussiert das aufgenommene Lichtbüschel in die Blendenebene B und erzeugt eine sekundäre Lichtquelle 5. Die Aperturverteilung am Ort der sekundären Lichtquelle 5 entspricht dabei der Feldausleuchtung. Die Feldwaben 1 können plan realisiert sein, wenn die Lichtstrahlen mit der geforderten Konvergenz auf die Feldwaben 1 treffen. Andernfalls weisen sie eine sammelnde Wirkung auf, um die sekundären Lichtquellen 5 zu erzeugen.

Der Abbildungsmaßstab zwischen Feldwabe und Feld ist durch das Verhältnis der Abstände sekundäre Lichtquelle 5 - Retikel 3 und Feldwabe 1 - sekundäre Lichtquelle 5 gegeben.

Figur 2 zeigt den Lichtverlauf ausgehend von einer erfindungsgemäß ausgebildeten Feldwabe 6 mit anamorphotischer Wirkung zum Retikel 3.

Mit Feldwaben mit anamorphotischer Wirkung 6 kann für die tangentiale Abbildung (y-Richtung) und für die sagittale Abbildung (x-Richtung) ein unterschiedlicher Abbildungsmaßstab eingestellt werden. Dadurch wird die sekundäre Lichtquelle in eine tangentiale 7 und eine sagittale Linienquelle 9 aufgespalten.

Das Aspektverhältnis der Feldwabe kann dadurch gegenüber dem Aspektverhältnis des auszuleuchtenden Feldes deutlich reduziert werden. Die Feldwaben können zylinderförmig realisiert sein, wenn die sagittalen oder die tangentialen Lichtstrahlen mit der geforderten Konvergenz auf die Feldwaben 6 treffen.

In Figur 3 ist der Grenzfall der kritischen Beleuchtung dargestellt, bei der sich die tangentiale Lichtquelle 7 in der Retikelebene 3 befindet. Ein erfindungsgemäßes Beleuchtungssystem kann folgende Einzelkomponenten aufweisen:

- eine Kollektoreinheit, z.B. für eine Laser-Plasma-Quelle, einen Ellipsoidspiegel, der das beispielsweise von einer Laser-Plasma-Quelle abgestrahlte Licht sammelt und die Quelle auf eine sekundäre Lichtquelle abbildet,

- eine Feldwabenplatte, die beispielsweise aus einer Vielzahl von Einzelspiegeln besteht, die das kollimierte Lichtbüschel in Teilbündel zerlegt und die Teilbündel in der Retikelebene überlagert. Die Feldwaben sind in einer Ausführungsform der Erfindung als Zylinderwaben ausgelegt, die im x-Schnitt plan und im y-Schnitt eine zerstreuende Wirkung aufweisen. Bei einer derartigen Ausführungsform liegen am Ort der sekundären Lichtquelle des Kollektorspiegels die sagittalen sekundären Linienquellen, da die Feldwaben im x-Schnitt plan sind und somit keine optische Wirkung aufweisen. Durch die zerstreuende Wirkung in y-Richtung kommen die tangentialen sekundären Linienquellen zwischen sagittalen sekundären Lichtquellen und Bildebene bzw. Retikelebene zum Liegen. Die Waben werden dabei so ausgerichtet, daß ihre Bilder in der Retikelebene zur Überlagerung kommen. Diesbezüglich wird auf die US 6 198 793 und entsprechende EP 0 955 641 A1 mit dem Titel "Illumination system, particularly for EUV-Lithography", der Anmelderin verwiesen.

Neben den zuvor beschriebenen Komponenten weist ein erfindungsgemäßes Beleuchtungssystem eine Feldlinsengruppe, umfassend einen oder mehrere Feldspiegel auf. Vorliegend wird die Feldlinsengruppe aus zwei grazing incidence Toroidspiegeln gebildet, die das Ringfeld formen, die Uniformität der Scan-Energie einstellen und die Austrittspupille des Beleuchtungssytems in die Eintrittspupille des Objektivs legt. Unter Scan-Energie versteht man das Linienintegral in Scan-Richtung über die Intensität.

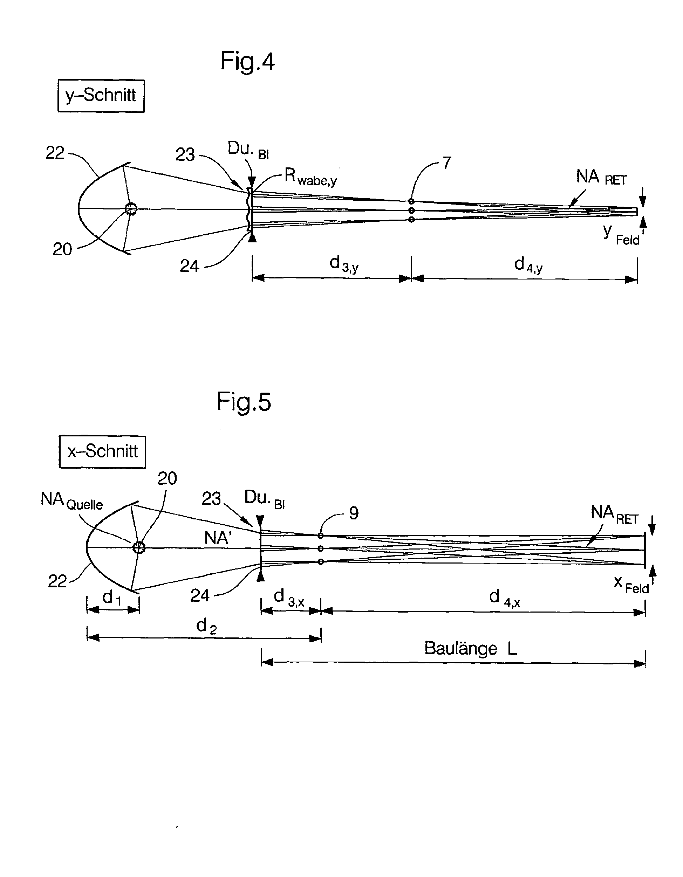

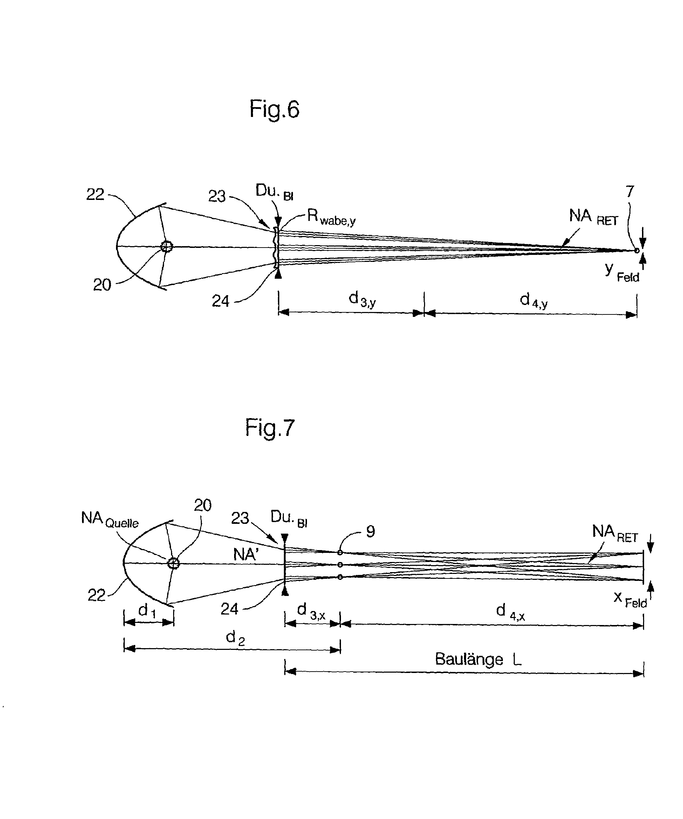

In den Figuren 4 bis 7 sind die Abkürzungen eingezeichnet, wie sie in der nachfolgenden Systemableitung verwendet werden. Zur besseren Darstellung ist das System linear aufgezogen. Die Figuren 4 und 5 zeigen ein System mit Feldwaben mit anamorphotischer Wirkung mit köhlerscher Beleuchtung in x- und y-Richtung. Die Figuren 6 und 7 zeigen ein System mit anamorphotischen Feldwaben und köhlerscher Beleuchtung in x-Richtung sowie kritischer Beleuchtung in y-Richtung.

In den Fig. 4 - 7 werden dieselben Bezugszeichen wie in den nachfolgenden Figuren verwandt, es bezeichnen: 20 die Lichtquelle, 22 den Kollektorspiegel, 23 die Wabenplatte, 24 die Feldwaben der Wabenplatte 23.

Mit nachfolgenden Größen wurden die Ableitungen vorgenommen.

- Radius des Ringfeldes R = 200 mm, Segment = 30° für die erste, zweite und vierte Ausführungsform, bzw. R = 100 mm,

Segment = 60° für die dritte Ausführungsform, Feldhöhe $\pm$ 3.0 mm. Dies entspricht einem Rechteckfeld von 105 mm x 6 mm,

- Apertur am Retikel: $NA_{Ret}$ = 0.025,
- Apertur an der Quelle: $NA_{Quelle}$ = 0.999,

- $d_1$ = 100.0 mm,
- Baulänge L= $d_3$ + $d_4$ = 1400 mm,
- Anzahl der Waben, die in einer x-Zeile Platz finden: $anz_x$, wobei die Anzahl ein Maß für die Zahl der sekundären Lichtquellen bzw. die Homogenität der Pupillenfüllung ist.
- $anz_x$ = 6 in der ersten, zweiten und vierten Ausführungsform
- $anz_x$ = 4 in der dritten Ausführungsform
- in der ersten Ausführungsform:

   Aspektverhältnis der Waben (x/y) = 1
   in der zweiten und vierten Ausführungsform:
   Aspektverhältnis der Waben (x/y) = 4.0
   in der dritten Ausführungsform:
   Aspektverhältnis der Waben (x/y) = 17,5

- $DU_{BL}$: Durchmesser der Feldwabenpupille
- $x_{Wabe}$: Größe einer Feldwabe in x-Richtung
- $y_{Wabe}$: Größe einer Feldwabe in y-Richtung
- $x_{Feld}$: Größe des auszuleuchtenden Feldes in x-Richtung
- $y_{Feld}$: Größe des auszuleuchtenden Feldes in y-Richtung
- $\beta^X_{Wabe}$: Abbildungsmaßstab in x-Richtung
- $\beta^Y_{Wabe}$: Abbildungsmaßstab in y-Richtung
- $R^X_{Wabe}$: Krümmungsradius der Feldwabe in x-Richtung
- $R^Y_{Wabe}$: Krümmungsradius der Feldwabe in y-Richtung
- NA': Apertur nach dem Kollektorspiegel
- R: Radius des Kollektorspiegels
- $E_x$: Exzentrität des Kollektorspiegels

Die in den Figuren 4 bis 7 eingezeichneten Größen sind durch folgende Gleichungen miteinander verknüpft:

für die sagittale Abbildung git, wenn $R^X_{Wabe}$ = 0 mm:

$$NA_{Ret} = \frac{DU_{BL}/2}{L} \qquad \Rightarrow DU_{BL} = 2 \cdot L \cdot NA_{Ret}$$

$$\frac{DU_{BL}}{x_{Wabe}} = anz_x \qquad \Rightarrow x_{Wabe} = \frac{DU_{BL}}{anz_x}$$

$$\beta^x_{Wabe} = \frac{X_{Feld}}{X_{Wabe}} = \frac{d_4^{\,\prime\,x}}{d_3^{\,\prime\,x}} \qquad \Rightarrow \beta^x_{Wabe} = \frac{X_{Feld}}{X_{Wabe}}$$

$$\Rightarrow d_4^{\,\prime\,x} = d_3^{\,\prime\,x} \cdot \beta^x_{Wabe}$$

$$L = d_3^{\,\prime\,x} + d_4^{\,\prime\,x} \qquad \Rightarrow d_3^{\,\prime\,x} = \frac{L}{1 + \beta^x_{Wabe}}$$

$$NA^{\prime} = \frac{DU_{BL}/2}{d_3^{\,\prime\,x}} \qquad \Rightarrow NA^{\prime} = \frac{DU_{BL}/2}{d_3^{\,\prime\,x}}$$

$$\tan(\theta) = -\frac{(1-Ex) \cdot \sin(\theta^{\prime})}{2\sqrt{Ex} - (1-Ex) \cdot \cos(\theta^{\prime})} \qquad \Rightarrow Ex = f(NA_{QU}, NA^{\prime})$$

$$Ex = \left(\frac{sk - s1}{sk + s1}\right)^2 = \left(\frac{d_2 - d_1}{d_2 + d_1}\right)^2 \qquad \Rightarrow d2 = d1 \cdot \frac{1 + \sqrt{Ex}}{1 - \sqrt{Ex}}$$

$$Ex = 1 - \frac{R}{a} \qquad \Rightarrow R = \frac{d_1 + d_2}{2} \cdot (1 - Ex)$$

Für die tangentiale Abbildung gilt:

$$(x/y) = \frac{x_{Wabe}}{y_{Wabe}} \qquad \Rightarrow y_{Wabe} = \frac{x_{Wabe}}{(x/y)}$$

$$\beta^y_{Wabe} = \frac{y_{Feld}}{y_{Wabe}} = \frac{d_4^y}{d_3^y} \qquad \Rightarrow \beta^y_{Wabe} = \frac{y_{Feld}}{y_{Wabe}}$$

$$\Rightarrow d_4^y = d_3^y \cdot \beta^y_{Wabe}$$

$$L = d_3^y + d_4^y \qquad \Rightarrow d_3^y = \frac{L}{1 + \beta^y_{Wabe}}$$

$$\frac{2}{R_{Wabe}^{y}} = \frac{1}{d_3^{y}} - \frac{1}{d_3^{x}} \qquad \Rightarrow R_{Wabe}^{y} = \frac{2 \cdot d_3^{y} \cdot d_3^{x}}{d_3^{x} - d_3^{y}}$$

Für den Fall der kritisch-köhlerschen Beleuchtung gilt speziell für die tangentiale Abbildung:

$$\beta_{WABE}^{Y} = 0 \qquad \Rightarrow \beta_{WABE}^{Y} = 0$$

$$\Rightarrow d_4^{y} = d_3^{y} \cdot 0 = 0 \ mm$$

$$L = d_3^{y} + d_4^{y} \qquad \Rightarrow d_3^{y} = \frac{L}{1+0} = L$$

$$\frac{2}{R_{Wabe}^{y}} = \frac{1}{d_3^{y}} - \frac{1}{d_3^{x}} \qquad \Rightarrow R_{Wabe}^{y} = \frac{2 \cdot L \cdot d_3^{x}}{d_3^{x} - L}$$

Setzt man die zuvor angegebenen Größen als Designvorgaben in die obigen Formeln ein, so ergeben sich alle Systemparameter ohne Feldlinse bzw. Feldspiegel. Für sämtliche nachfolgenden Rechenbeispiele wird im folgenden der gleiche Kollektorteil und x-Schnitt verwendet.

Nachfolgend die Berechnung für ein System mit Feldwaben mit anamorphotischer Wirkung und köhlerscher Beleuchtung in x- und y-Richtung sowie sechs Feldwaben pro Zeile gemäß Figuren 4 und 5.

**Ausführungsbeispiele 1 und 2**

Sagittale Abbildung für quadratische und 4:1 Waben:

$$DU_{BL} = 2 \cdot L \cdot NA_{Ret} = 2 \cdot 1400 \ mm. \ 0.025 = 70.0 \ mm$$

$$x_{Wabe} = \frac{DU_{BL}}{anz_x} = \frac{70.0 \ mm}{anz_x} \approx 11.0 \ mm$$

$$\beta_{Wabe}^x = \frac{x_{Feld}}{x_{Wabe}} = \frac{105.0 \, mm}{11.0 \, mm} = 9.545$$

$$d_3^x = \frac{L}{1 + \beta_{Wabe}^x} = \frac{1400.0 \, mm}{1 + 9.545} = 132.759 \, mm$$

$$d_4^x = d_3^x \cdot \beta_{Wabe}^x = 132.759 \, mm \cdot 9.545 = 1267.241 \, mm$$

$$NA' = \frac{DU_{BL}/2}{d_3^x} = \frac{70.0 \, mm/2}{132.759 \, mm} = 0.255$$

$$Ex = f(NA_{QU}, NA') = 0.579$$

$$d2 = d1 \cdot \frac{1 + \sqrt{Ex}}{1 - \sqrt{Ex}} = 100.0 \, mm \cdot \frac{1 + \sqrt{0.579}}{1 - \sqrt{0.579}} = 737.599 \, mm$$

$$R = \frac{d_1 + d_2}{2} \cdot (1 - Ex) = \frac{100.0 \, mm + 737.599 \, mm}{2} \cdot (1 - 0.579) = 176.122 \, mm$$

Tangentiale Abbildung für quadratische Waben (Ausführungsbeispiel 1):

$$y_{Wabe} = \frac{x_{Wabe}}{(x/y)} = \frac{11.0 \, mm}{1.0} = 11.0 \, mm$$

$$\beta^{y}_{Wabe} = \frac{y_{Feld}}{y_{Wabe}} = \frac{6.0\ mm}{11.0\ mm} = 0.545$$

$$d^{y}_3 = \frac{L}{1 + \beta^{y}_{Wabe}} = \frac{1400\ mm}{1 + 0.545} = 905.8\ mm$$

$$d^{y}_4 = d^{y}_3 \cdot \beta^{y}_{Wabe} = 905.8\ mm \cdot 0.545 = 494.1\ mm$$

$$R^{y}_{Wabe} = \frac{2 \cdot d^{y}_3 \cdot d^{x}_3}{d^{x}_3 - d^{y}_3} = \frac{2 \cdot 905.8\ mm \cdot 132.759\ mm}{132.759\ mm - 905.8\ mm} = -311.1\ mm$$

Tangentiale Abbildung für 4:1 Waben (Ausführungsbeispiel 2):

$$y_{Wabe} = \frac{x_{Wabe}}{(x/y)} = \frac{11.0\ mm}{4.0} = 2.75\ mm$$

$$\beta^{y}_{Wabe} = \frac{y_{Feld}}{y_{Wabe}} = \frac{6.0\ mm}{2.75\ mm} = 2.182$$

$$d^{y}_3 = \frac{L}{1 + \beta^{y}_{Wabe}} = \frac{1400\ mm}{1 + 2.182} = 440.0\ mm$$

$$d^{y}_4 = d^{y}_3 \cdot \beta^{y}_{Wabe} = 440.0\ mm \cdot 2.182 = 960.0\ mm$$

$$R_{Wabe}^{y} = \frac{2 \cdot d_3^{y} \cdot d_3^{x}}{d_3^{x} - d_3^{y}} = \frac{2 \cdot 440.0\,mm \cdot 132.759\,mm}{132.759\,mm - 440.0\,mm} = -380.2\,mm$$

Nachfolgende Berechnung in den Ausführungsbeispielen 3 und 4 zeigen ein System mit kritisch-köhlerscher Beleuchtung für 17,5:1 sowie 4:1-Waben:

**Ausführungsbeispiel 3**

Feldwaben mit Aspektverhältnis 17,5: 1 und 4 Waben pro Zeile
Sagittale Abbildung für 17,5:1 Waben

$$DU_{BL} = 2 \cdot L \cdot NA_{Ret} = 2 \cdot 1400\,mm \cdot 0.025 = 70.0\,mm$$

$$x_{Wabe} = \frac{DU_{BL}}{4.0} = \frac{70.0\,mm}{4.0} \approx 17.5\,mm$$

$$\beta_{Wabe}^{x} = \frac{x_{Feld}}{x_{Wabe}} = \frac{105.0\,mm}{17.5\,mm} = 6.0$$

$$d_3^{x} = \frac{L}{1 + \beta_{Wabe}^{x}} = \frac{1400.0\,mm}{1 + 6.0} = 200.0\,mm$$

$$d_4^{x} = d_3^{x} \cdot \beta_{Wabe}^{x} = 200.0\,mm \cdot 6.0 = 1200.0\,mm$$

$$NA' = \frac{DU_{BL}/2}{d_3^{x}} = \frac{70.0\,mm/2}{200.0\,mm} = 0.175$$

$$Ex = f (NA_{QU}, NA') = 0.695$$

$$d2 = d1 \cdot \frac{1 + \sqrt{Ex}}{1 - \sqrt{Ex}} = 100.0 \, mm \cdot \frac{1 + \sqrt{0.695}}{1 - \sqrt{0.695}} = 1101.678 \, mm$$

$$R = \frac{d_1 + d_2}{2} \cdot (1 - Ex) = \frac{100.0 \, mm + 1101.678 \, mm}{2} \cdot (1 - 0.695) = 183.357 \, mm$$

Tangentiale Abbildung für 17,5:1 Waben:

$$y_{Wabe} = \frac{x_{Wabe}}{(x/y)} = \frac{17.5 \, mm}{17.5} = 1.0 \, mm$$

$$d_3^y = L = 1400.0 \, mm$$

$$R_{Wabe}^y = \frac{2 \cdot L \cdot d_3^x}{d_x^3 - L} = \frac{2 \cdot 1400.0 \, mm \cdot 200.0 \, mm}{200.0 \, mm - 1400.0 \, mm} = - 466.667 \, mm$$

**Ausführungsbeispiel 4**

Feldwaben mit dem Aspektverhältnis 4:1 und 6 Waben pro Zeile
Sagittale Abbildung für 4:1 Waben:

$$DU_{BL} = 2 \cdot L \cdot NA_{Ret} = 2 \cdot 1400 \, mm \cdot 0.025 = 70.0 \, mm$$

$$x_{Wabe} = \frac{DU_{BL}}{6.0} = \frac{70.0 \, mm}{6.0} \approx 11.0 \, mm$$

$$\beta_{Wabe}^{x} = \frac{x_{Feld}}{x_{Wabe}} = \frac{105.0\,mm}{11.0\,mm} = 9.545$$

$$d_{3}^{\prime x} = \frac{L}{1 + \beta_{Wabe}^{x}} = \frac{1400.0\,mm}{1 + 9.545} = 132.759$$

$$d_{4}^{\prime x} = d_{3}^{\prime x} \cdot \beta_{Wabe}^{x} = 132.759\,mm \cdot 9.545 = 1267.241\,mm$$

$$NA' = \frac{DU_{BL}/2}{d_{3}^{\prime x}} = \frac{70.0\,mm/2}{132.759\,mm} = 0.25\text{[}$$

$$Ex = f(NA_{QU}, NA') = 0.579$$

$$d2 = d1 \cdot \frac{1 + \sqrt{Ex}}{1 - \sqrt{Ex}} = 100.0\,mm \cdot \frac{1 + \sqrt{0.579}}{1 - \sqrt{0.579}} = 737.599\,mm$$

$$R = \frac{d_{1} + d_{2}}{2} \cdot (1 - Ex) = \frac{100.0\,mm + 737.599\,mm}{2} \cdot (1 - 0.579) = 176.122\,mm$$

Tangentiale Abbildung für 4:1 Waben:

$$y_{Wabe} = \frac{x_{Wabe}}{(x/y)} = \frac{11.0\,mm}{4.0} = 2.75\,mm$$

$$d_3^{\,y} = L = 1400.0\,mm$$

$$R_{Wabe}^{\,y} = \frac{2 \cdot L \cdot d_3^{\,x}}{d_x^3 - L} = \frac{2 \cdot 1400.0\,mm \cdot 132.759\,mm}{132.759\,mm - 1400.0\,mm} = -293.334\,mm$$

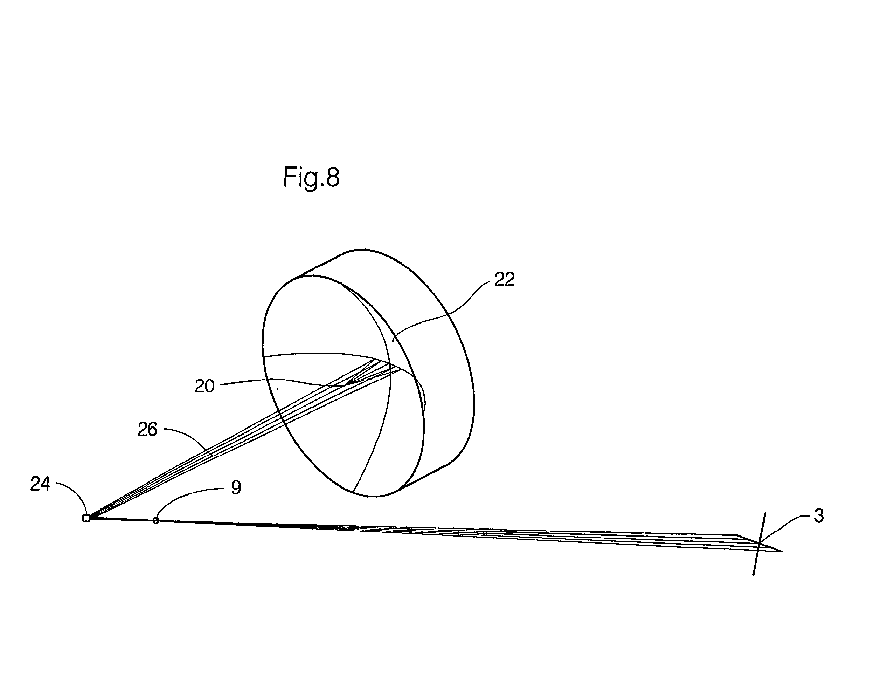

In dem nachfolgend detaillierter anhand der Figuren 8 bis 12 beschriebenen Ausführungsbeispiel 1 wird ein System mit köhlerscher Beleuchtung und quadratischen Feldwaben (Feldwaben mit Aspektverhältnis 1:1) betrachtet.

Die Figuren 8 bis 12 zeigen den sich für einen Aufbau mit Quelle 20, Kollektorspiegel 22, Wabenplatte 23 mit quadratischen Feldwaben 24 ergebenden Strahlenverlauf und Ausleuchtungen. Gleiche Bauteile wie in den Figuren 1 bis 4 werden mit denselben Bezugsziffern belegt. Die betrachtete Lichtquelle in den nachfolgenden Ausführungsbeispielen ist eine Laser-Plasma-Lichtquelle, ohne Beschränkung hierauf. Denkbar sind auch andere Lichtquellen wie beispielsweise Pinch-Plasma- oder Synchrotron-Strahlungsquellen. Speziell für den Fall der betrachteten Laser-Plasma-Lichtquelle ist die Kollektoreinheit als sammelnder Kollektorspiegel 22 ausgebildet. Für die anderen Lichtquellen ist eine jeweils an die Quelle angepaßte Kollektoreinheit vorgesehen.

Figur 8 zeigt ein sagittales Strahlenbündel 26, das die Zylinderwabe in der Mitte der Wabenplatte 23 ausleuchtet. Die sammelnde Wirkung im Sagittalschnitt wird allein durch den Kollektorspiegel 22 aufgebracht. Der x-Schnitt der Feldwaben 24 ist plan. Die sagittale sekundäre Lichtquelle 9 liegt dicht bei der Feldwabe 24.

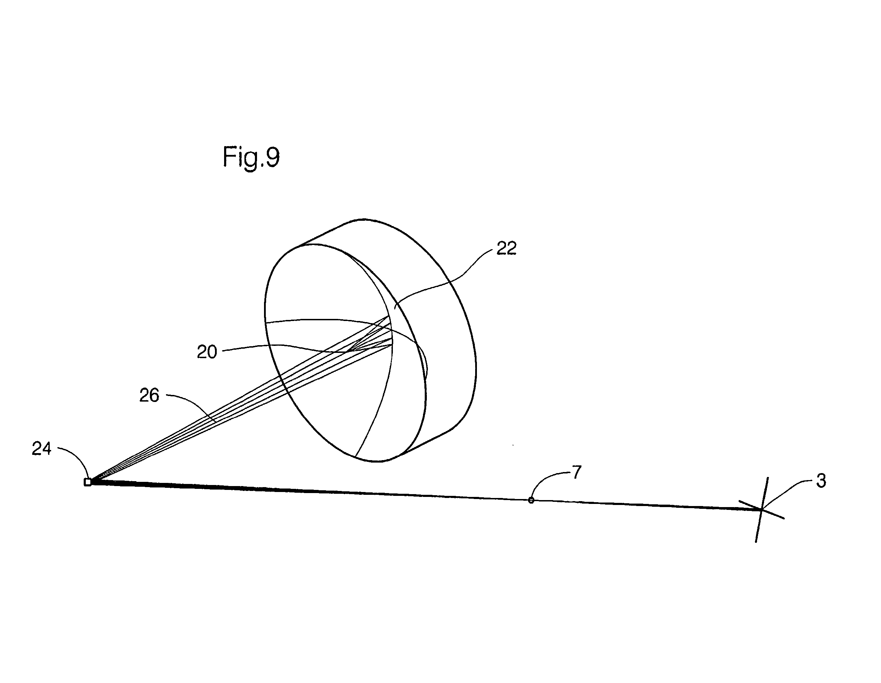

Figur 9 zeigt ein tangentiales Strahlenbündel 28, das die Feldwabe 24 in der Mitte der Wabenplatte ausleuchtet. Der y-Schnitt der Feldwabe wirkt zerstreuend, so daß die tangentiale sekundäre Lichtquelle 7 zum Feld bzw. Retikel 3 hin verschoben wird. Dadurch verringert sich der Waben-Abbildungsmaßstab.

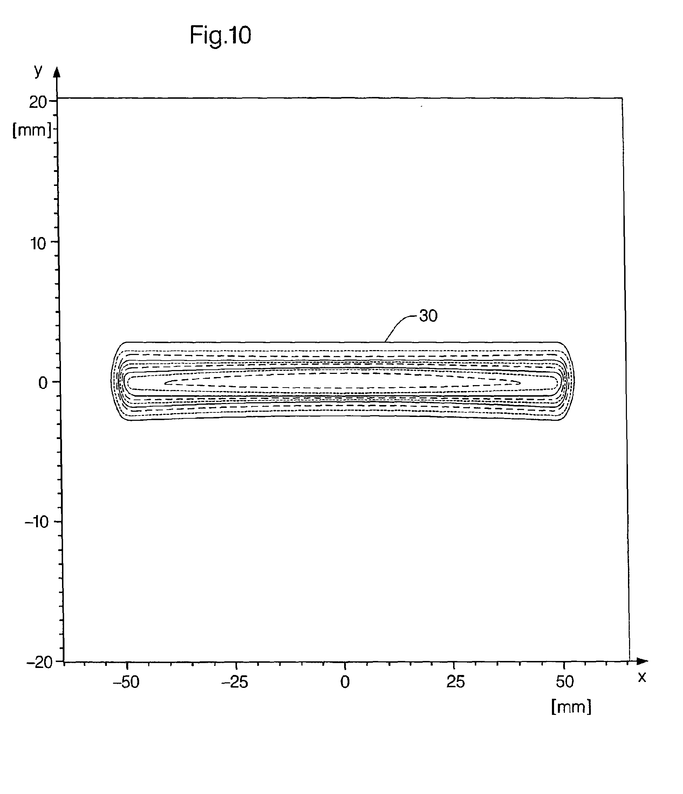

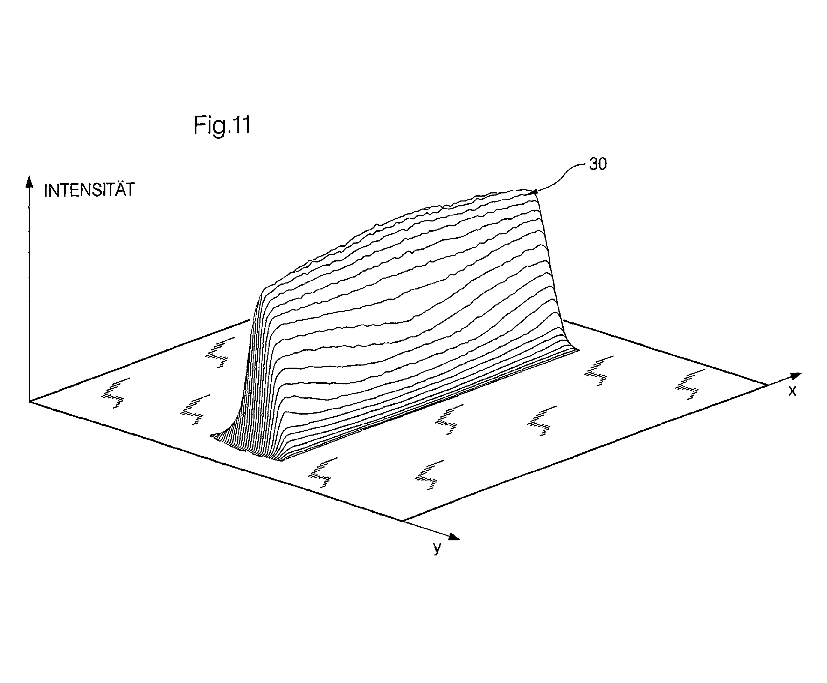

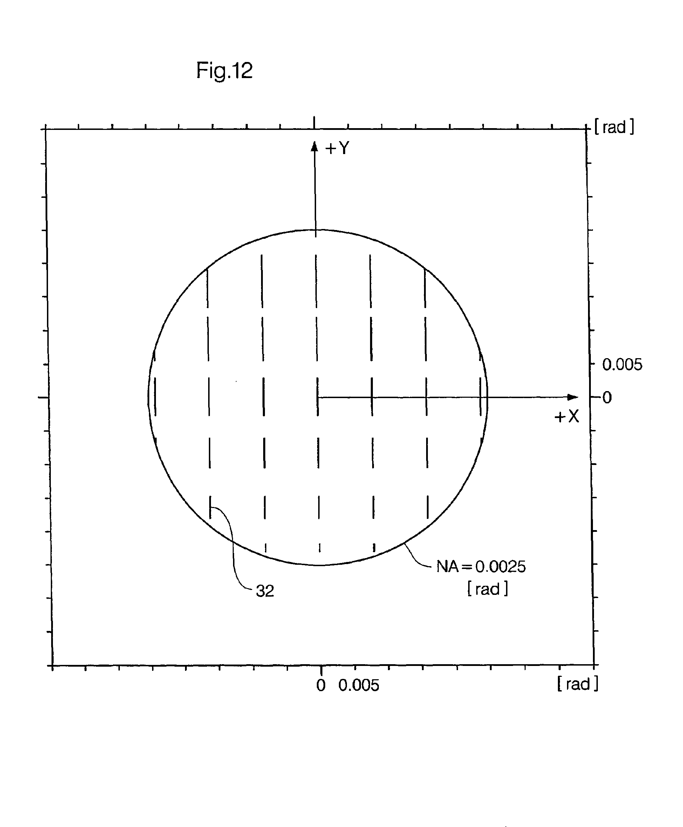

Die Figuren 10 bis 11 zeigen die Ausleuchtung des Rechteckfeldes (105.5 mm x 6.0 mm) 30 in der vorläufigen Bildebene bei Verwendung der zuvor niedergelegten Designdaten. Figur 10 ist eine Höhenliniendarstellung; Figur 11 eine perspektivische Darstellung der Intensitätsverteilung. In den Figuren 10 bis 11 wird auf eine vorläufige Bildebene Bezug genommen, da die Betrachtung zunächst ohne Feldspiegel bzw. Feldlinse erfolgt. Figur 12 zeigt die Pupillenausleuchtung für einen Punkt in der Feldmitte. Die Pupillenausleuchtung für einen Punkt zeigt an, aus welchen Richtungen, angegeben als Winkel, der betreffende Punkt Licht sieht. Die Strahlwinkel sind auf den Schwerstrahl bezogen. Entsprechend der Anordnung der Feldwaben auf einem quadratischem Gitter, ergibt sich ein quadratisches Gitter von Teilpupillen 32. Die Teilpupillen 32 sind in y-Richtung in die Länge gezogen, da die Lichtquelle in die sagittale und tangentiale Bildebene unterschiedlich groß abgebildet wird.

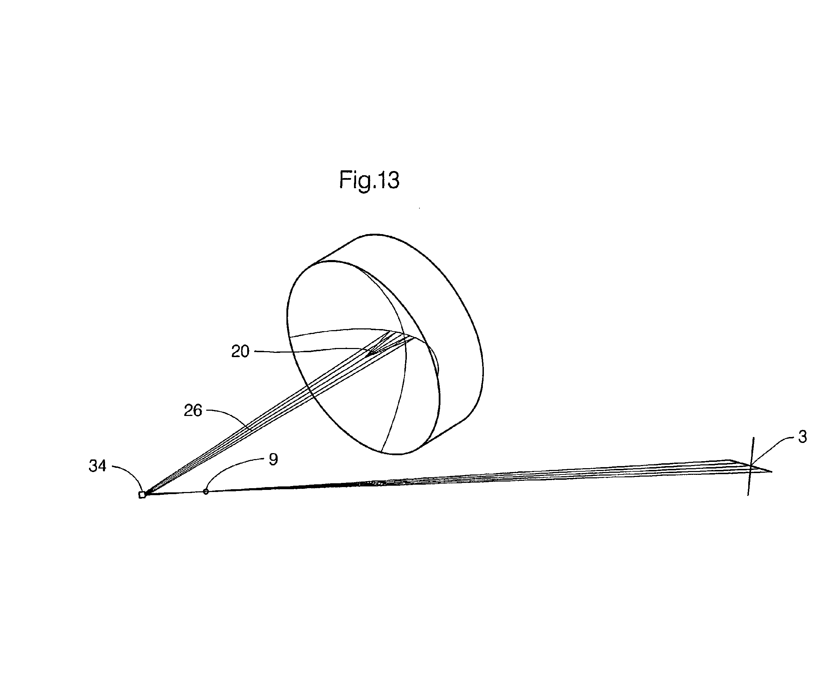

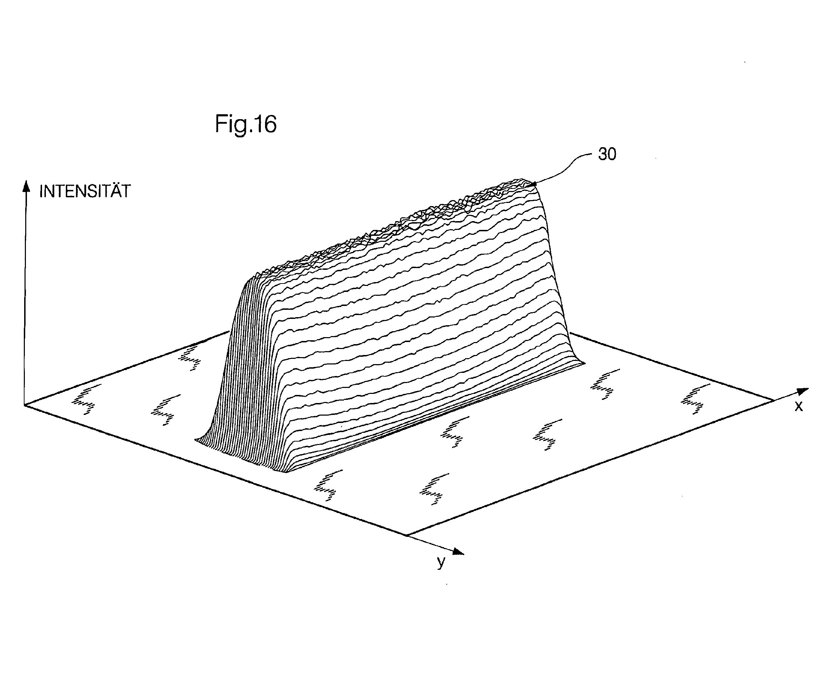

Nachfolgend wird detailliert Ausführungsbeispiel 2 mit 4:1 Waben und köhlerscher Beleuchtung beschrieben anhand der Figuren 13 bis 17. Gleiche Bauteile wie in den vorangegangenen Figuren sind mit denselben Bezugsziffern belegt.

Die Figuren 13 bis 17 zeigen die sich für den Aufbau mit Quelle 20, Kondensor 22, Wabenplatte 23 mit 4:1 Zylinderwaben 34 (Waben mit Aspektverhältnis 4:1) ergebenden Strahlverlauf und Ausleuchtung.

Figur 13 zeigt ein sagittales Strahlenbündel 26. Es ergibt sich die gleiche Konfiguration wie bei den quadratischen Feldwaben gemäß Figur 8.

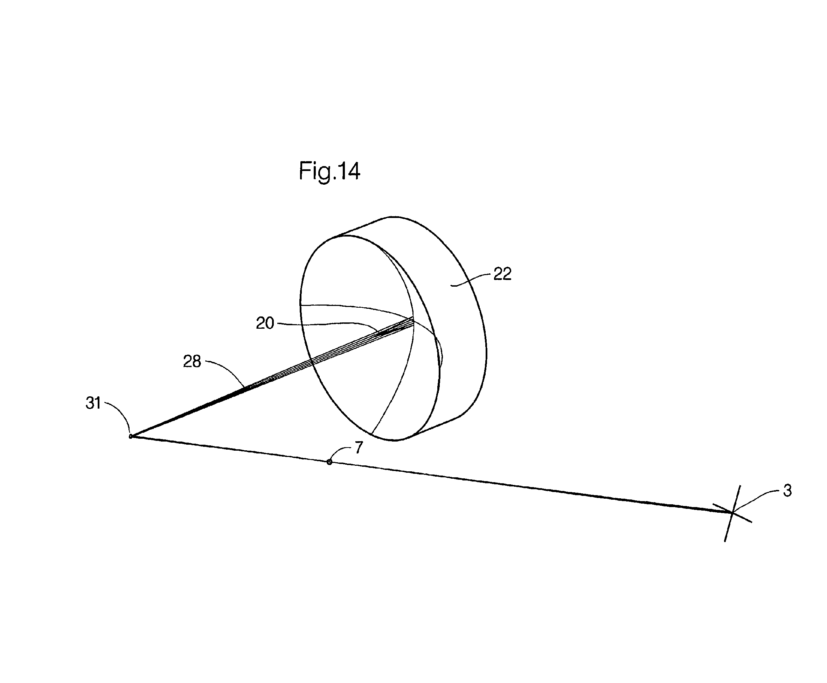

Figur 14 zeigt ein tangentiales Strahlenbündel 28. Im Vergleich zu den quadratischen Waben gemäß Ausführungsbeispiel 1 ist die zerstreuende Wirkung der Feldwabe geringer.

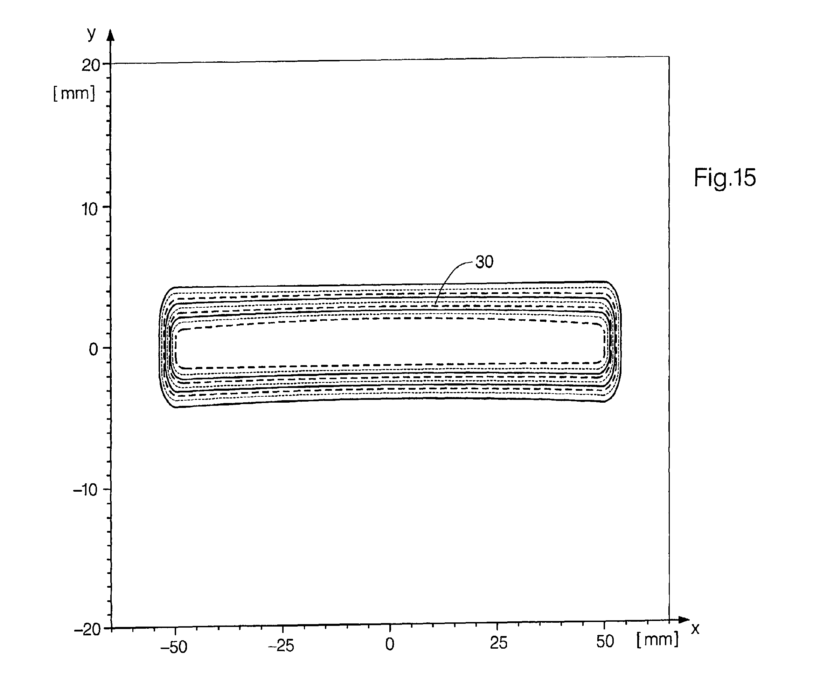

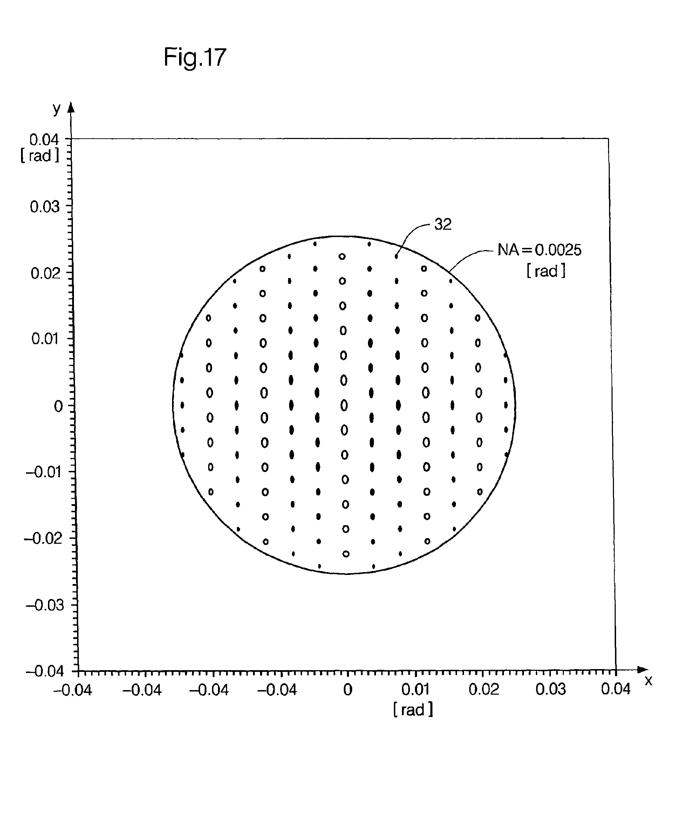

In den Figuren 15 bis 16 ist die Ausleuchtung des Rechteckfeldes 30 (106 mm x 6 mm) in der vorläufigen Bildebene dargestellt. Figur 17 zeigt die Pupillenausleuchtung 32 für einen Punkt in der Feldmitte. Die Strahlwinkel sind auf den Schwerstrahl bezogen. Bei der Anordnung der Feldwaben ist es vorteilhaft, daß bei einem Aspektverhältnis von 4:1 das Gesamtgitter durch zwei Rechteck-Gitter erzeugt wird, die in x-Richtung um eine halbe Seitenlänge und in y-Richtung um eine ganze Seitenlänge verschoben sind. Diese Maßnahme führt zu einer gleichmäßigen Verteilung der Teilpupillen 32 im Vergleich zu einer Anordnung auf einem reinen Rechteckgitter mit Zeilen/Spaltenanordnung der Feldwaben. Entsprechend der Wabenverteilung auf der Wabenplatte ergeben sich zwei um die halbe Seitenlänge verschobene Gitter von Teilpupillen 32. Die Teilpupillen 32 sind in y-Richtung leicht elliptisch, da die Lichtquelle in die sagittale und tangentiale Bildebene unterschiedlich groß abgebildet wird.

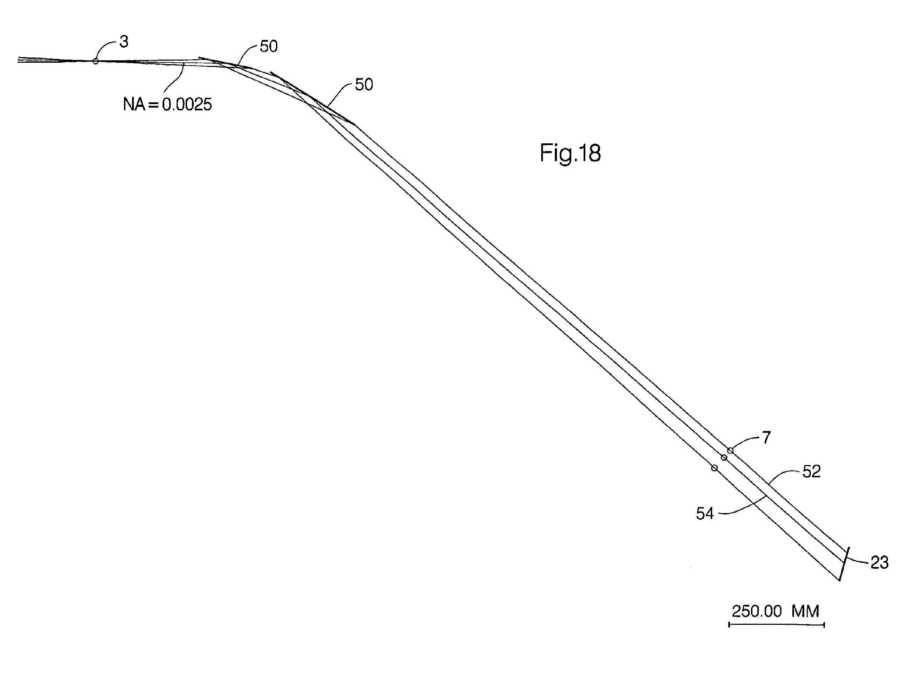

Anhand der nachfolgenden Abbildungen 18 bis 22 soll der Einfluß der Feldlinsengruppe 50 umfassend eine oder mehrere Feldlinsen bzw. Feldspiegel und das Verfahren der Rückwärtsrechnung zur Bestimmung der Lage der Feldwaben auf der Feldwabenplatte bzw. der Zylinderwabenplatte bei vorgegebener Verteilung der Teilpupillen in der Austrittspupille näher beschrieben werden.

Die Feldlinsengruppe, umfassend wenigstens eine Feldlinse bzw. einen Feldspiegel erfüllt im EUV-Beleuchtungssystem insbesondere die nachfolgenden Aufgaben:

- Umwandlung des Rechteckfeldes in ein Ringfeld.
- Einstellen der Telezentrie-Bedingung, d.h. Anpassung der Austrittspupille des Beleuchtungssystems an die Eintrittspupille des Objektives.
- Korrektur der Uniformität der Scan-Energie.

Bei Aufspaltung in eine Ebene mit sagittalen sekundären Lichtquellen und eine Ebene mit tangentialen sekundären Lichtquellen kann die Feldlinsengruppe mit Feldlinsen bzw. Feldspiegel 50 so ausgelegt sein, daß sowohl die sagittale wie auch die tangentiale sekundäre Lichtquelle in die vorgegebene Austrittspupille abgebildet werden. Denkbar ist auch, daß eine Blendenebene am Ort der sagittalen sekundären Lichtquelle, am Ort der tangentialen sekundären Lichtquellen oder dazwischen liegt und in die vorgegebene Austrittspupille abgebildet wird. Für eine kritisch-köhlersche Beleuchtung wird die Blendenebene vorteilhafter Weise am Ort der sagittalen sekundären Lichtquellen angeordnet. In dieser Blendenebene können Maskiereinrichtungen oder eine Aperturblende angeordnet sein. Sind die Feldspiegel als grazing incidence Spiegel ausgebildet, so können sie eine Toroid-Grundform aufweisen. Wie zuvor erläutert, bildet die Feldlinse bzw. der Feldspiegel 50 die sekundären Lichtquellen 7,9 oder eine Blendenebene in die Austrittspupille des Beleuchtungssystems, die vorliegend mit der Eintrittspupille des nachfolgenden Projektionsobjektivs zusammenfällt, ab.

Figur 18 zeigt einen Teil des Beleuchtungssystems aufgetragen entgegen der Lichtrichtung: Retikel 3, eine Feldlinsengruppe mit zwei Feldspiegeln 50, tangentiale sekundäre Lichtquelle 7, Wabenplatte 23.

Bei der Auslegung eines Designs eines EUV-Beleuchtungssystems gemäß der Erfindung wird zunächst das Design der Feldlinse bzw. des Feldspiegels in Vorwärtsrichtung bestimmt, indem die zentrale Feldwabe so abgebildet wird, daß sich das vorgegebene Ringfeld ergibt und das Bild der tangentialen und sagittalen sekundären Lichtquelle gebildet von der zentralen Feldwabe in der Mitte der Austrittspupille liegt. Die zentrale Feldwabe befindet sich in der Mitte des Feldwabenspiegels. Durch ihren Mittelpunkt verläuft die optische Achse. Werden nun ein Mittenstrahl 54 und die beiden Randstrahlen 52 von einem Punkt auf der optischen Achse ausgehend von der Retikelebene 3 entgegen der Lichtrichtung bei einem System mit derartigen Feldspiegeln 50 durchgerechnet, so zeigt sich, daß der Auftreffpunkt des Mittenstrahls auf der Wabenplatte nicht mittig zwischen den Auftreffpunkten der Randstrahlen liegt.

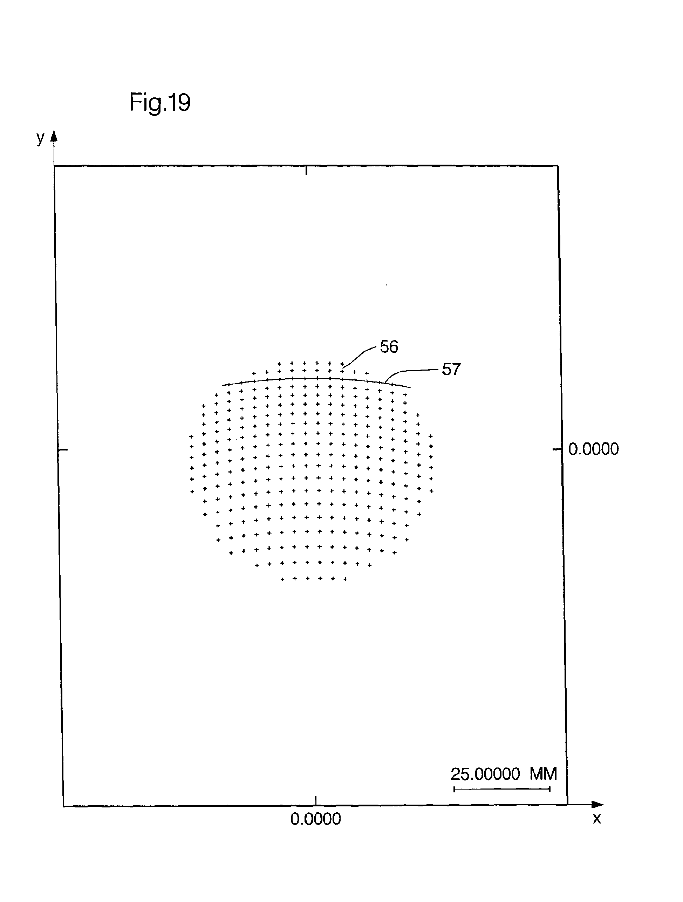

Rechnet man ein Strahlengitter mit Strahlen auf einem quadratischen Gitter mit NA=0,025 ausgehend von der Retikelebene bei einem System mit derartigen Feldspiegeln 50 rückwärts, so zeigt Fig. 19, daß die

Durchstoßpunkte auf gebogenen Linien 57 liegen, deren Abstände zudem verzeichnet sind.

Diese Verzeichnung macht sich umgekehrt bemerkbar, wenn man von einer regelmäßigen Feldwabenausrichtung ausgeht.

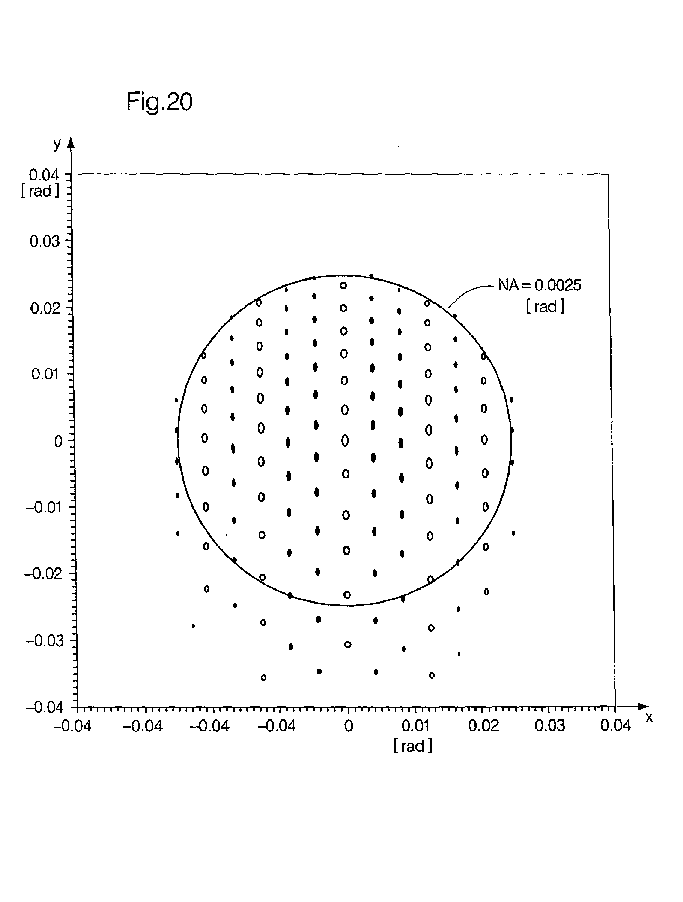

Ordnet man die Feldwaben auf zwei gegeneinander verschobenen gleichmäßigen Rechteckgittern an und stellt die Kippwinkel der Waben so ein, daß die Mittenstrahlen die Retikelebene auf der optischen Achse schneiden, so ergibt sich für eine derartige Anordnung eine Pupillenausleuchtung für einen Punkt in der Mitte der Retikelebene - wie in Figur 20 gezeigt. Deutlich zu erkennen ist, daß die Lage der Teilpupillen aufgrund der Pupillenaberrationen der Feldspiegel in y-Richtung verzeichnet ist. In positiver y-Richtung werden die Teilpupillen zusammengedrängt, in negativer Richtung auseinandergezogen.

Um eine gleichmäßige Verteilung der Teilpupillen in der Austrittspupille des Beleuchtungssystems zu erreichen, gibt man eine gleichmäßige Verteilung der Teilpupillen in der Austrittspupille des Beleuchtungssytems, die vorliegend mit der Eintrittspupille des Objektives zusammenfällt, vor und führt eine Rückwärtsrechnung durch.

Wie zuvor beschrieben wird zunächst eine Rasterung von Teilpupillen, das sind vorliegend die Bilder der sekundären Lichtquellen, in der Austrittspupille des Beleuchtungssystems vorgegeben. Anschließend wird zur Bestimmung der Lage der Feldwaben auf der Feldwabenplatte bzw. Zylinderwabenplatte der Schwerstrahl der Teilpupillen durch die Feldlinse hindurch bis zur Wabenebene, d.h. bis zur Feldwabenplatte, gerechnet, wobei die Durchstoßpunkte der Schwerstrahlen mit dieser Ebene die Position der Feldwaben bestimmt. Die Richtung der rückwärts gerechneten Schwerstrahlen ist durch den Ort der Teilpupille und dadurch gegeben, daß die Schwerstrahlen durch die Mitte der Retikelebene laufen.

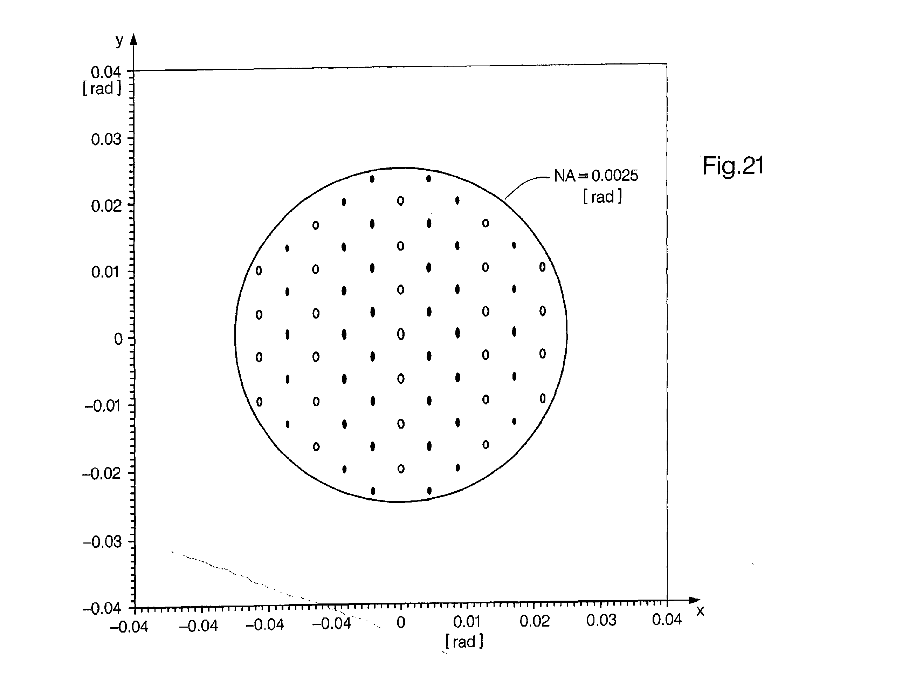

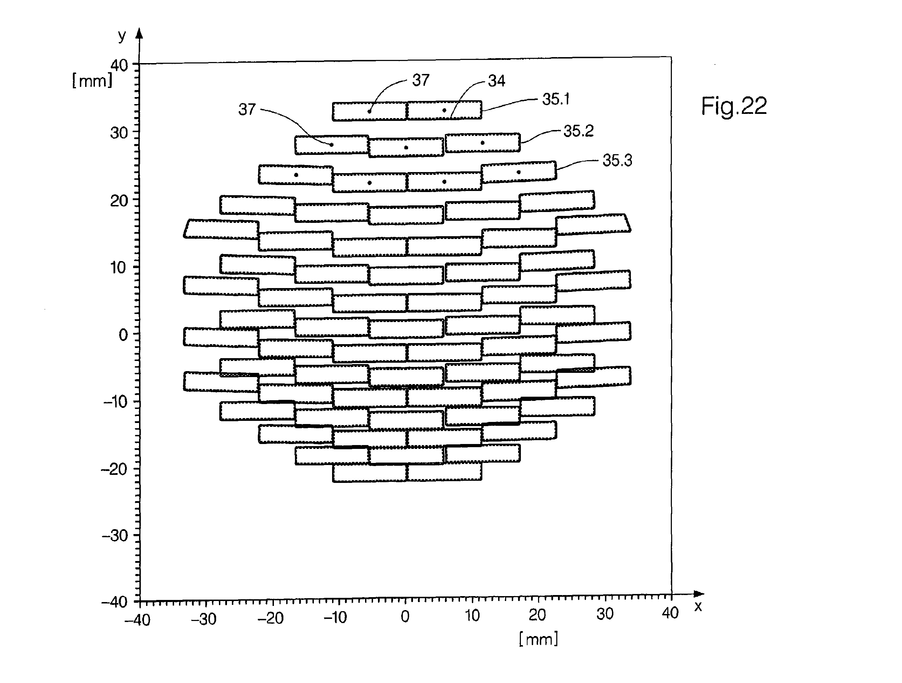

Legt man die in Figur 21 dargestellte Pupillenausleuchtung für die Feldmitte zugrunde, so ergibt sich die in Fig. 22 dargestellte Verteilung der 4:1-Feldwaben 34. Während die Feldwaben 34 in y-Richtung im unteren Teil der Wabenplatte dicht gepackt sind, nimmt ihr Abstand nach oben zu. Dadurch entstehen Lücken zwischen den Feldwaben in y-Richtung, die zu einem Wirkungsgrad von η ≈ 60 % führen. Der Wabenanordnung ist die rotationssymmetrische Beleuchtung des Kollektorspiegels als Höhenlinienprofil überlagert. Durch die unsymmetrische Anordnung der Feldwaben in y-Richtung ist ein Intensitäts-Tilt in der Pupillenausleuchtung zu erwarten. Er kann kompensiert werden, indem man die Reflektivitäten der Waben entsprechend anpaßt. Möglich ist auch, die Quelle und Kollektoreinheit so zu gestalten, daß sich trotz der verzerrten Wabenanordnung eine symmetrische Pupillenausleuchtung ergibt.

Figur 22 zeigt des weiteren die Anordnung der Feldwaben 34 in gekrümmt verlaufenden Zeilen 35.1, 35.2, 35.3 etc. Jede Feldwabenzeile 35.1, 35.2, 35.3 etc. umfaßt mehr als eine Feldwabe 34. Die Mittelpunkte 37 der Feldwaben 34 zweier aufeinanderfolgender Zeilen, beispielsweise der Zeilen 35.1 und 35.2, sind zur gleichmäßigeren Füllung der Pupille in x-Richtung gegeneinander verschoben. Vorliegend beträgt die Verschiebung 1/2 der Wabenlänge in x-Richtung. Des weiteren in Figur 22 gut zu erkennen, die Abnahme des Abstandes der einzelnen Zeilen 35.1, 35.2, 35.3 etc. in negativer y-Richtung, bis die Feldwaben 34 der einzelnen Zeilen in den untersten Zeilen ohne Abstand direkt aneinander anliegen.

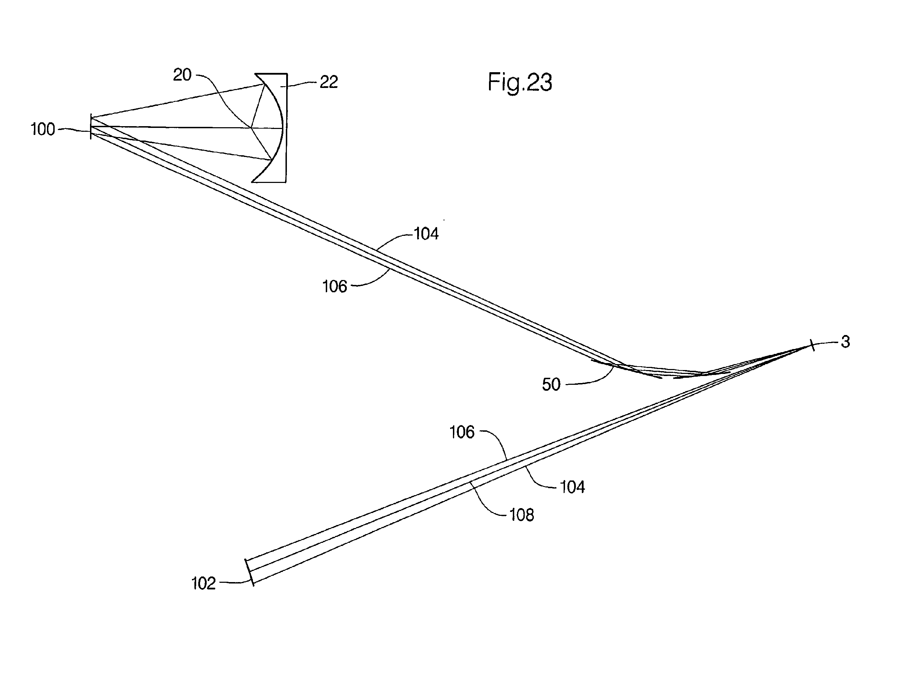

Nachfolgend sollen in den Figuren 23 bis 28 die Lichtstrahlverläufe sowie die Intensitäten für ein Gesamtsystem Laser-Plasma-Quelle 20, Kollektor 22, Feldwabenplatte 100, Feldlinsengruppe 50, Retikel und Austrittspupille, das wie zuvor beschrieben ausgelegt wurde, dargestellt werden.

Die Feldwabenplatte 100 wurde wie zuvor beschrieben mit 4:1 Feldwaben in verzeichneter Anordnung ausgeführt.

Die in Figur 23 dargestellten Randstrahlen 104, 106 des Gesamtsystems treffen sich auf dem Retikel 3 und sind bis zur Eintrittspupille des Objektivs 102 dargestellt. Sie verlaufen erst nach der Feldlinsengruppe 50 symmetrisch zum Mittenstrahl 108. Dadurch ist der Kollektor 22 asymmetrisch zur optischen Achse ausgeleuchtet. Die "Abstrahlkeule" der Quelle sollte zur Kompensation entsprechend ausgerichtet werden.

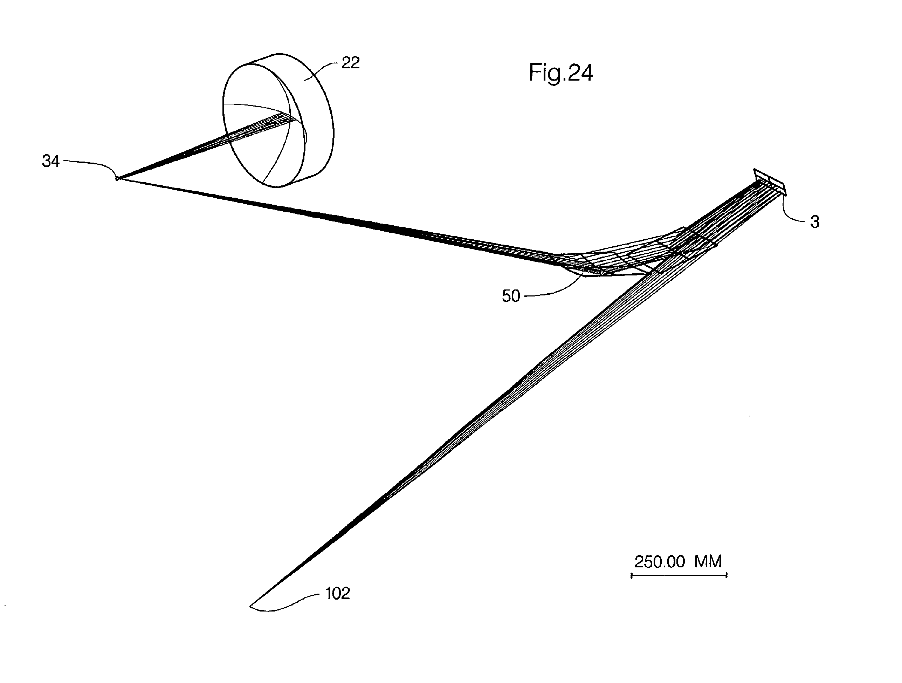

In Figur 24 ist ein Büschel von Sagittal-Strahlen gezeigt, der die zentrale Zylinder-Wabe (0,0) 34 der Feldwabenplatte trifft. Die Strahlen leuchten den Ring auf dem Retikel mit der korrekten Orientierung aus und treffen sich in der Eintrittspupille des Objektivs 102.

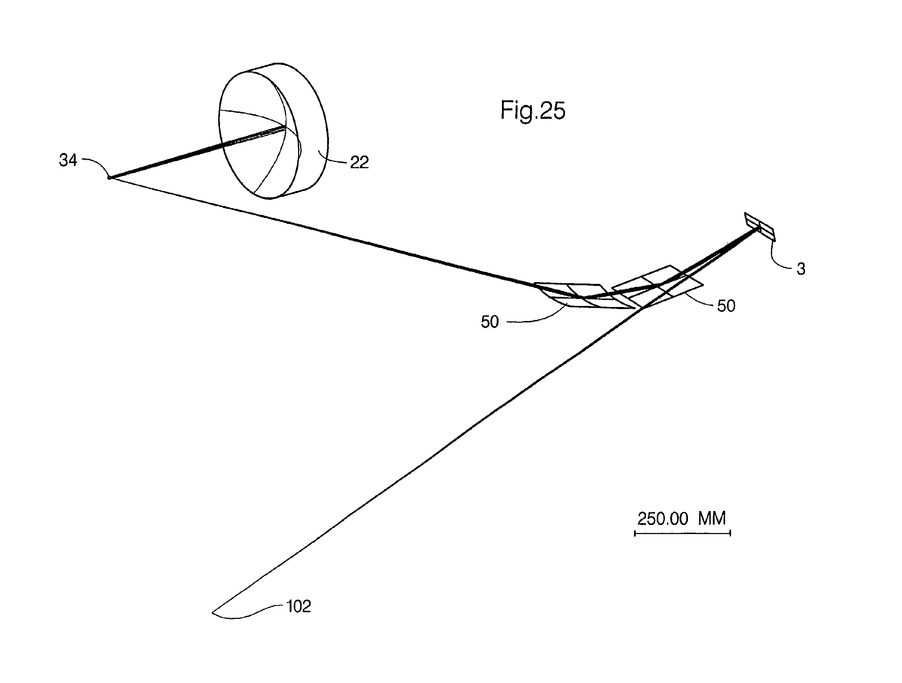

Figur 25 zeigt einen Büschel von Tangential-Strahlen, der die zentrale Zylinderwabe 34 trifft. Die Strahlen leuchten den Ring entlang der y-Achse aus und treffen sich in der Eintrittspupille des Objektivs 102.

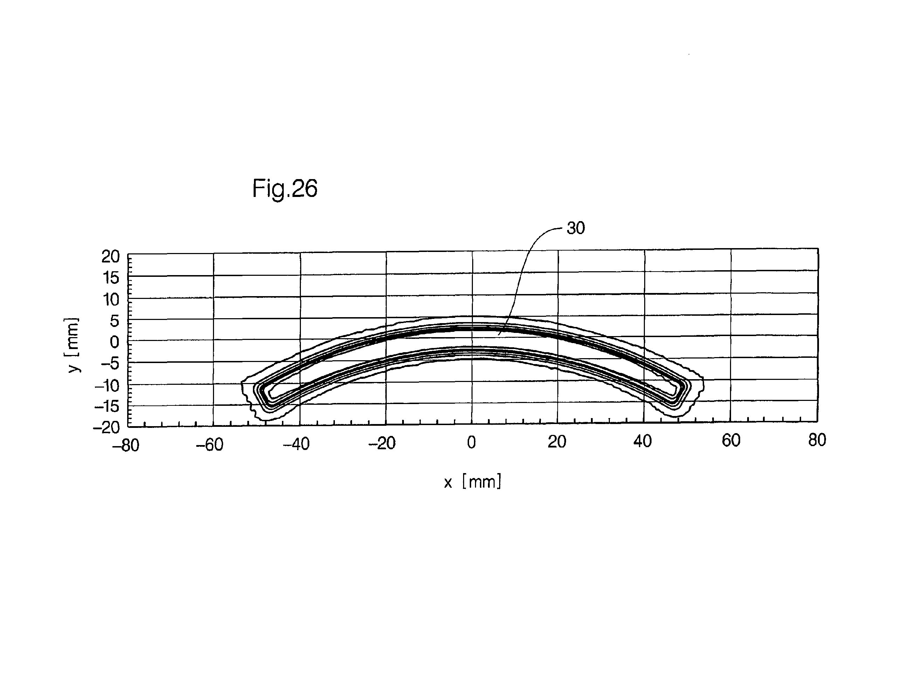

In Figur 26 ist die Ausleuchtung des Retikels mit dem Ringfeld 30 (R = 100 mm, Segment = 60°, Feldhöhe ± 3.0 mm) dargestellt.

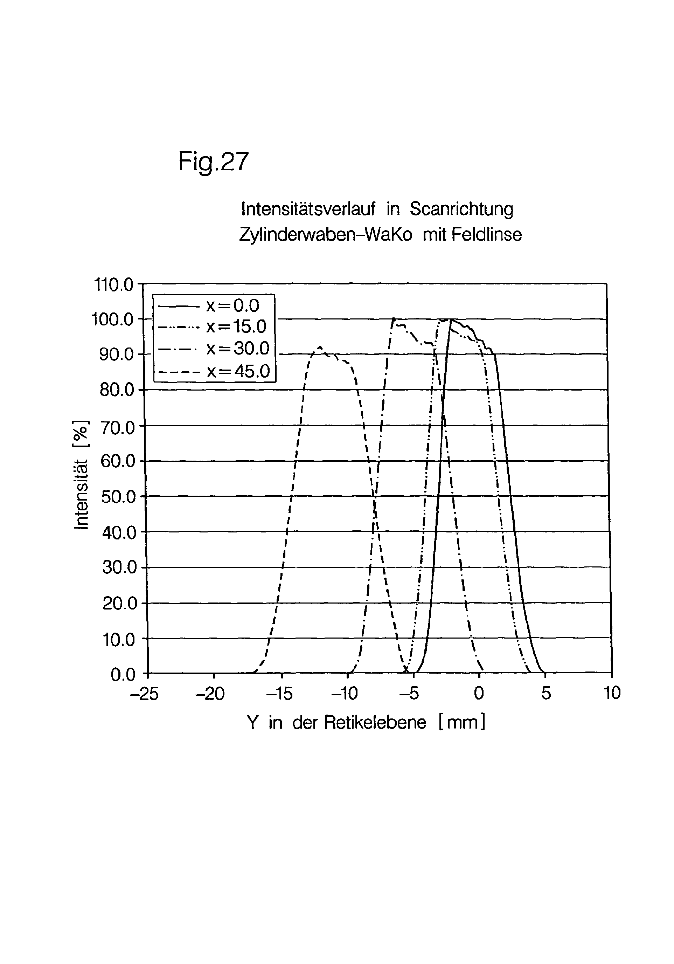

Figur 27 zeigt Intensitätsschnitte parallel zur y-Achse bei x = 0.0 mm, 15.0 mm, 30.0 mm und 45.0 mm. Die maximale Intensität nimmt zum Feldrand leicht ab, vorliegend von 100 % auf 92 %. Die y-Breite der Intensitätsverteilungen nimmt zum Feldrand aufgrund der Geometrie des Ringes um 15 % zu.

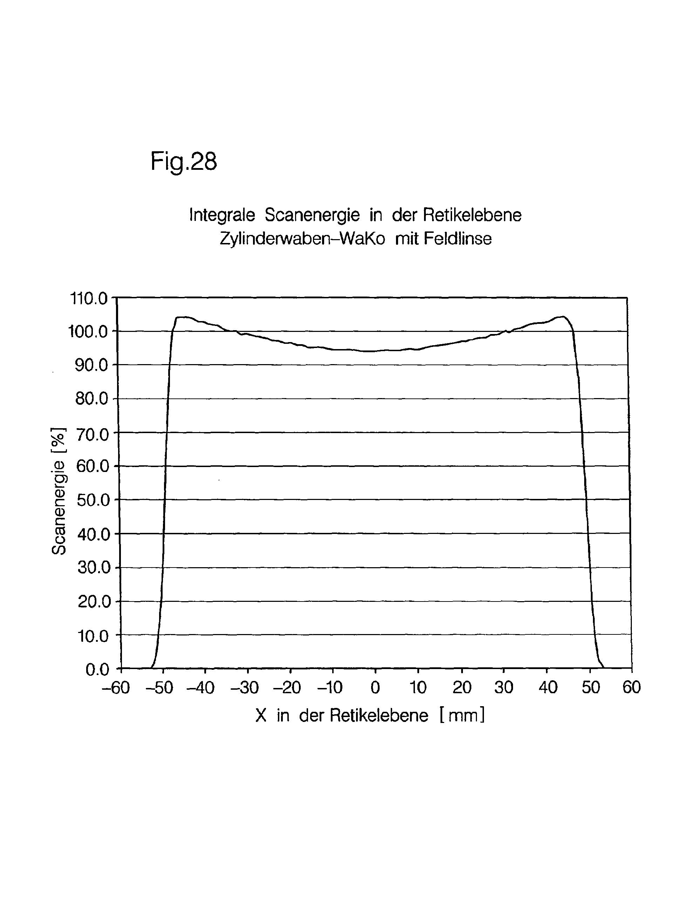

In Figur 28 ist die für den Lithographie-Prozeß entscheidende integrale Scanenergie, d.h. die Integration der Intensität entlang des Scanweges gezeigt. Die integrale Scanenergie variiert zwischen 95 % und 105 %. Die Uniformität beträgt ± 5.0 %. Die Uniformitätseinbuße ist zum Teil durch die Geometrie des Rings bedingt, da der Scanweg um 15 % ansteigt. Durch das Design der Feldlinsengruppe konnte bereits ein Teil dieses Anstiegs durch ein Absenken der absoluten Intensität zum Feldrand kompensiert werden.

Alternativ oder gleichzeitig hierzu kann ein homogener Verlauf der Scan-Uniformität auch dadurch erreicht werden, daß man die Reflektivitäten der einzelnen Waben entsprechend einstellt. Dabei variiert die Reflektivität auf jeder Wabe zumindest entlang der x-Richtung.

Die in den Figuren 8 bis 28 beschriebenen Ausführungsformen 1 und 2 der Erfindung umfaßt als Lichtquelle eine Plasma-Licht-Quelle mit einem Quelldurchmesser von 50 µm. Bei derart gering ausgedehnten Lichtquellen ist die Beleuchtung köhlersch und man kann auf Pupillenwaben verzichten. Die Wabenabbildung erfolgt ähnlich wie bei einer Lochkamera. Bei Quellen mit größeren Durchmessern können die Feldwaben mit Hilfe von Pupillenwaben auf das Feld abgebildet werden. Ohne die Pupillenwaben würde es zu einer Kantenverbreiterung bzw. zu Verschmierung der Retikelausleuchtung kommen. Als Pupillenwaben können Zylinderwaben oder Toroidwaben verwendet werden. Kritisch ist vor allem die Ausleuchtung der schmalen Feldseite. Durch Zylinderwaben in der tangentialen Pupillenebene kann die Kantenbreite der Feldwabenbilder in y-Richtung verringert werden.

Nachfolgend sollen die Ausführungsbeispiele 3 und 4 mit Quellen mit einem Quelldurchmesser von 100 µm betrachtet werden.

Als Quelle wurde eine Quelle mit einer Ausdehnung von 100 µm verwendet, die in den Raumwinkel 2 π abstrahlt.

Das Aspektverhältnis der Feldwaben beträgt gemäß Ausführungsbeispiel 3 17,5:1. Es sind vier Waben pro Zeile auf der Feldwabenplatte angeordnet.

Die Größe des auszuleuchtenden Feldes beträgt 105 mm x 6 mm (30° Segment bei Grundradius 200 mm).

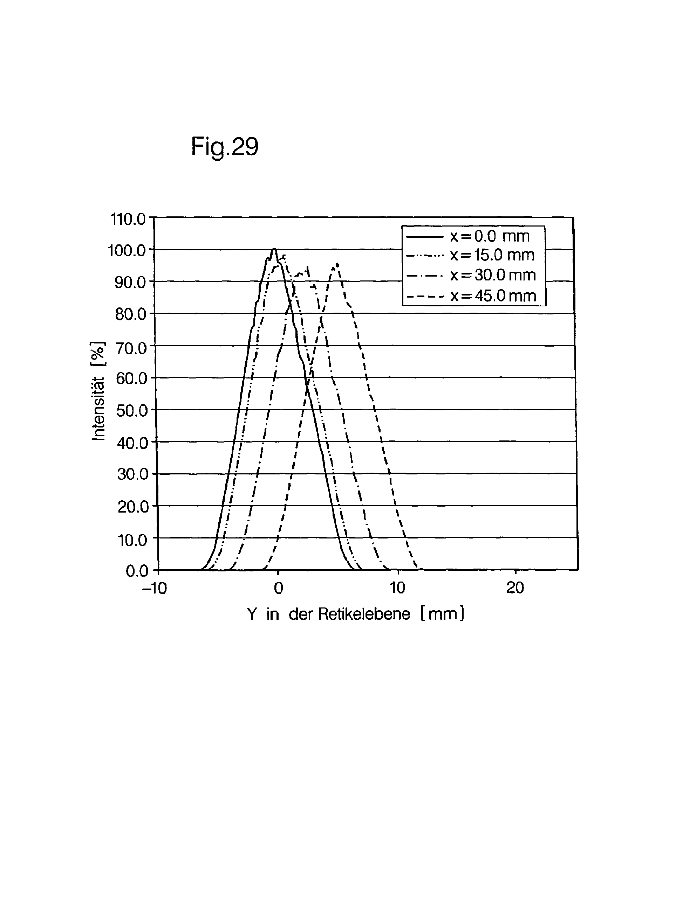

Figur 29 zeigt Intensitätsschnitte entlang der y-Richtung (Scan-Richtung) für verschiedene x-Werte für ein System mit köhlerscher Beleuchtung in x- und y-Richtung.

Die 100 µm-Quelle führt zu einer Kantenbreite von 7,2 mm.

Im Fall der Köhlerschen Beleuchtung in Figur 29 führt die Kantenbreite dazu, daß das Intensitätsplateau nicht erreicht wird, da die Kantenbreite bereits breiter ist wie das auszuleuchtende Feld. Der Sockel der Intensitätsverteilung hat eine Breite von 13,2 mm.

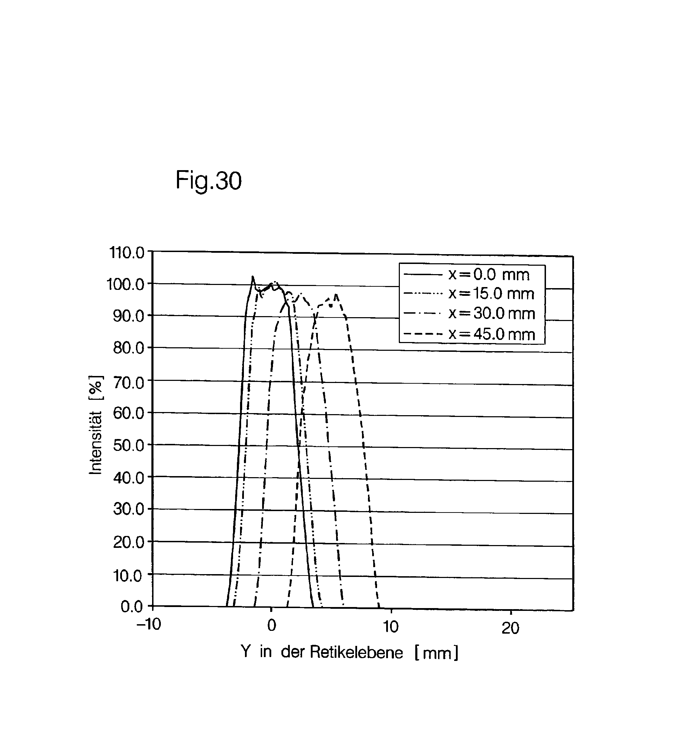

Figur 30 zeigt Intensitätsschnitte entlang der y-Richtung für verschiedene x-Werte für ein System mit kritisch-köhlerscher Beleuchtung gemäß Ausführungsbeispiel 3.

Auch für die kritisch-köhlersche Beleuchtung - Figur 30 - ist die Quellgröße 100 $\mu$m. Da die 100 $\mu$m Quelle auf ein Quellbild mit Durchmesser 7,2 mm abgebildet wird, weist der Sockel in diesem Fall eine Breite von 7,2 mm auf.

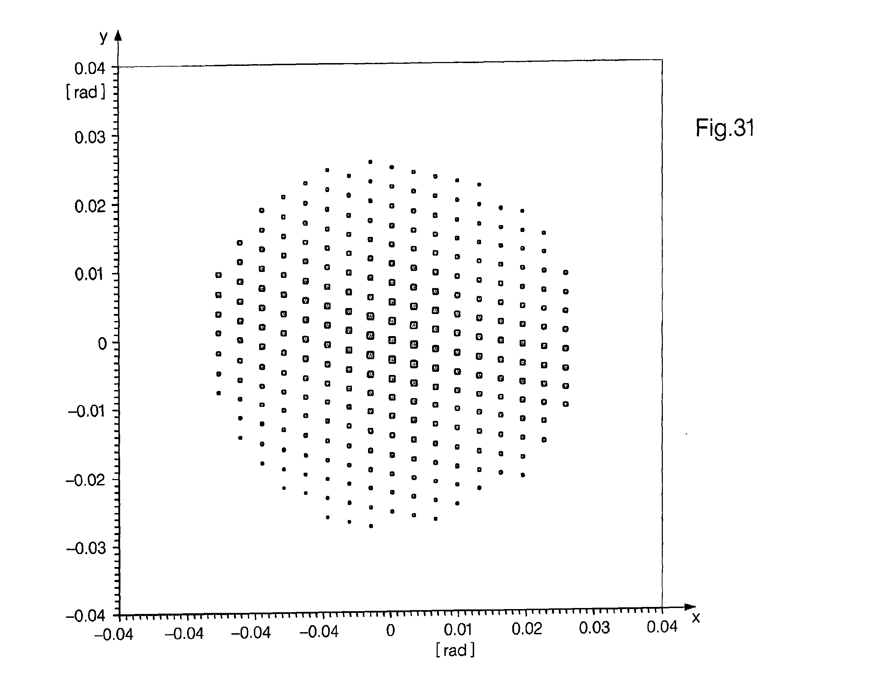

Figur 31 zeigt die Pupillenausleuchtung einer Anordnung gemäß Figur 30 für die Feldmitte. Die Teilpupillen sind entsprechend der Anordnung der Feldwaben verteilt. Die Zeilen der Feldwaben sind gegeneinander um jeweils 1/4 der Wabenlänge auf der Feldwabenplatte verschoben. Ohne Verschiebung der Wabenzeilen würden sich durchgehende Striche in der Pupillenverteilung ergeben, wie beispielsweise aus der US 5 677 939 bekannt.

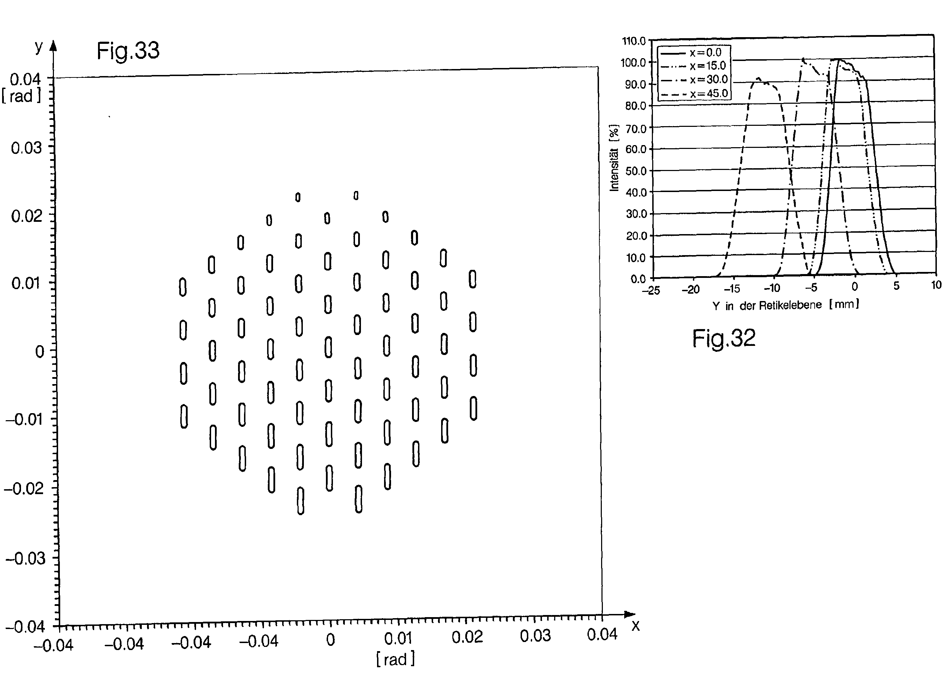

Figur 32 zeigt Intensitätsschnitte entlang der y-Richtung für verschiedene x-Werte für eine kritisch-köhlersche Beleuchtung, wobei die Feldwaben ein Aspektverhältnis von 4:1 gemäß Ausführungsbeispiel 4 aufweisen. In Ausführungsbeispiel 4 wurde die Feldlinsengruppe für ein 60°-Segment bei einem Grundradius von 100 mm ausgelegt. Dadurch wird der y-Offset der Intensitätsschnitte zum Feldrand hin und die geometrische Verbreiterung des Scanweges größer als in Ausführungsbeispiel 3.

Der Intensitätsschnitt gemäß Figur 32 bei x = 0 mm zeigt bei einer 100 $\mu$m Quelle die gleiche Breite von 7,2 mm wie im Fall der 17,5:1 Waben, da der Abbildungsmaßstab der Quelle unabhängig vom Wabenaspektverhältnis ist und im Prinzip nur von der quell- und retikelseitigen Apertur abhängt.

Die in Figur 33 dargestellte Pupillenausleuchtung für die Feldmitte für Waben mit Aspektverhältnis 4:1 ist durch strichförmige Teilpupillen gekennzeichnet, die typisch für kritisch-köhlersche Beleuchtungssysteme sind. Durch die Verschiebung der Feldwabenzeilen um jeweils eine halbe Wabenlänge werden die Striche entsprechend versetzt angeordnet.

Die sehr gleichmäßige Anordnung der Teilpupillen in der Austrittspupille des Beleuchtungssystems gemäß Ausführungsbeispiel 4 wurde durch eine verzeichnete Anordnung der Feldwaben erreicht.

Eine mögliche weitere Ausführungsform der Erfindung besteht darin, die anamorphotische Wirkung von den einzelnen Feldwaben der Feldwabenplatte auf den Kollektorspiegel zu übertragen. Dies ermöglicht es, mit Planfacetten bei gleichzeitig reduziertem Aspektverhältnis zu arbeiten. Der x-Schnitt des Kollektorspiegels bildet die Quelle in den sagittalen Fokus, der y-Schnitt in den tangentialen Fokus, ab.

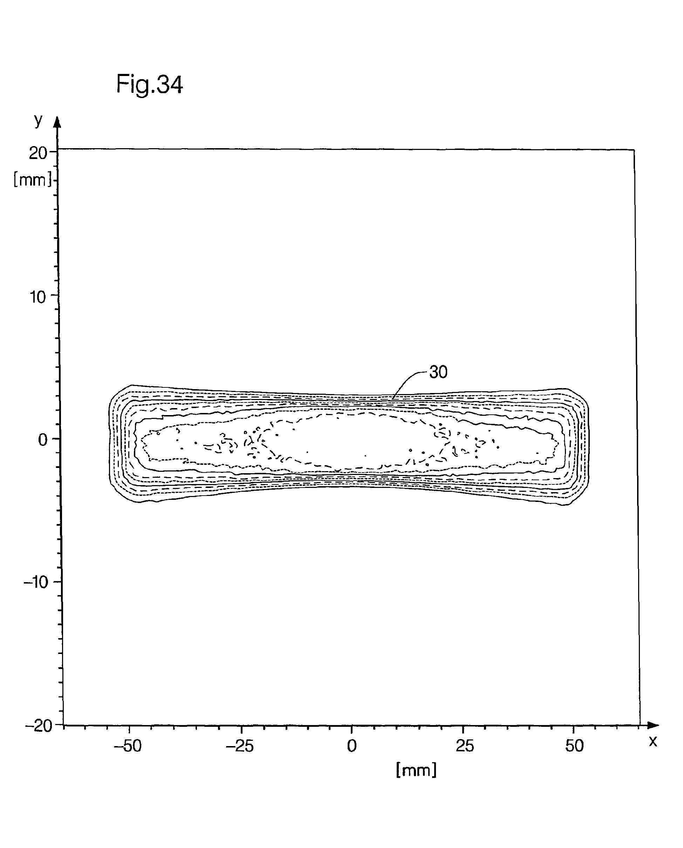

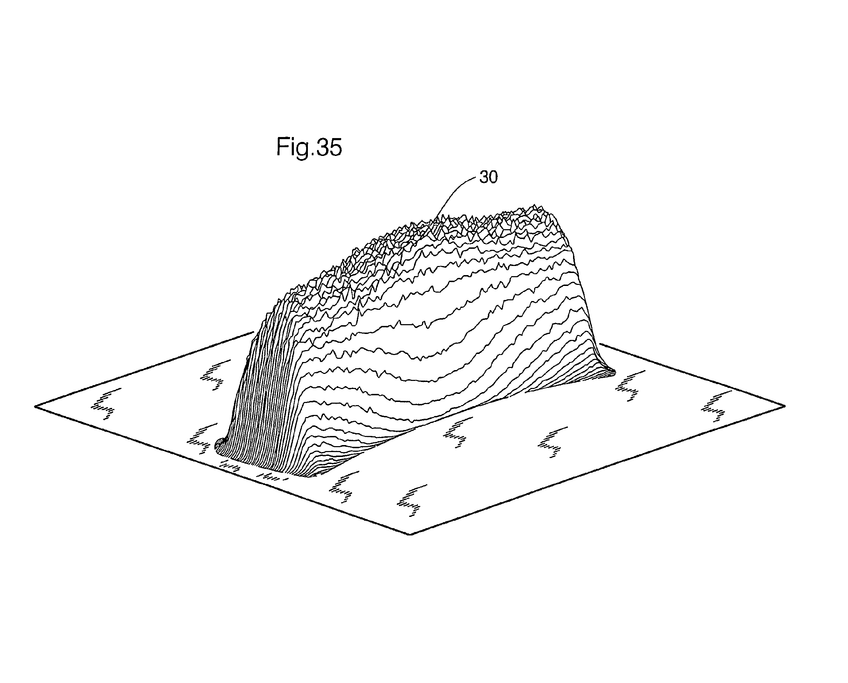

Die Figuren 34 und 35 zeigen die Ausleuchtung des Rechteckfeldes (106 mm x 6 mm) in der vorläufigen Bildebene einer Anordnung mit einem Kollektorspiegel, der eine anamorphotische Wirkung aufweist. Dabei wurden quadratische Feldwaben auf einem quadratischen Gitter verwendet.

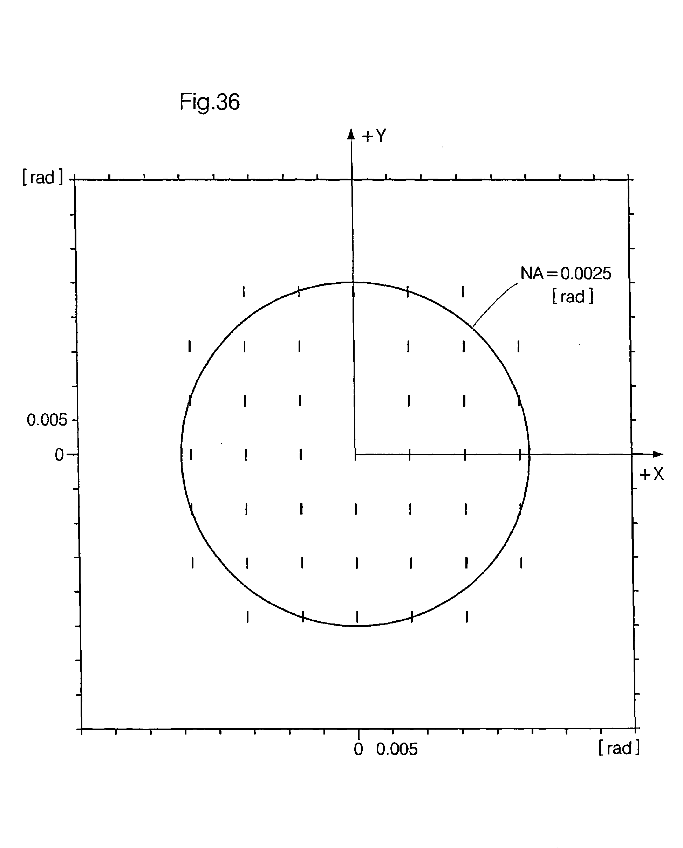

In Figur 36 ist die Pupillenausleuchtung in der Feldmitte dargestellt. Die Strahlwinkel sind auf den Schwerstrahl bezogen. Entsprechend der Wabenverteilung ergibt sich ein quadratisches Gitter von sekundären Lichtquellen.

Mit der Erfindung wird erstmals ein EUV-Beleuchtungssystem angegeben, bei der mit Hilfe von Komponenten mit anamorphotischer Wirkung das Waben-Aspektverhältnis von Feldwaben reduziert werden kann. Insbesondere ermöglicht es die Erfindung erstmals ein Feld mit Aspektverhältnis größer als 1:1 mit Waben mit kleinerem Aspektverhältnis als das Feldaspektverhältnis auszuleuchten. Dies hat eine ganz erhebliche Vereinfachung der Fertigung der Wabenplatten zur Folge. Ein weiterer Vorteil der Erfindung ist darin zu sehen, daß aufgrund des geringeren Aspektverhältnisses von beispielsweise 4:1 oder 1:1 der einzelnen Feldwaben eine einfachere Packung auf der Feldwabenplatte möglich ist und damit die Teilpupillen gleichmäßiger verteilt werden können im Vergleich zu einer reinen Spalten-Zeilen-Anordnung bei Waben mit großem Aspektverhältnis beispielsweise von 17,5:1.

**Patentansprüche**

1. Beleuchtungssystem, Insbesondere für die Lithographie mit Wellenlängen $\leq$ 193 nm, welches ein Feld mit einem Aspektverhältnis, das nicht 1:1 ist, beleuchtet,
   umfassend

   - eine Lichtquelle (20)
   - optische Komponenten zur Transformierung der Lichtquelle in sekundäre Lichtquellen, wobei
   - die optischen Komponenten eine anamorphotische Wirkung aufweisen, um
   - die sekundären Lichtquellen in tangentiale und sagittale sekundäre Lichtquellen aufzuspalten,
   - wobei
   - die optischen Komponenten wenigstens einen ersten Spiegel oder eine erste Linse umfassen, der bzw. die in Rasterelemente gegliedert ist, wobei die Rasterelemente eine zweidimensionale Anordnung aufweisen,

**dadurch gekennzeichnet, dass**
die Rasterelemente (34) des ersten Spiegels oder Linse ein Aspektverhältnis aufweisen, das kleiner als das Aspektverhältnis des Feldes ist.

2. Beleuchtungssystem nach Anspruch 1,
**dadurch gekennzeichnet, dass**
das Beleuchtungssystem eine Feldllnsengruppe umfassend wenigstens einen Feldspiegel oder eine Feldebene (50) aufweist.

3. Beleuchtungssystem nach Anspruch 1 oder Anspruch 2,
**dadurch gekennzeichnet, dass** das Beleuchtungssystem eine Bildebene (3) und eine Austrittspupille aufweist.

4. Beleuchtungssystem nach einem der Ansprüche 1 bis 3,
**dadurch gekennzeichnet, dass**
die anamorphotische Wirkung derart gewählt ist, dass die tangentialen sekundären Lichtquellen (7, 9) zwischen den sagittalen sekundären Lichtquellen und der Bildebene (3) zum Liegen kommen.

5. Beleuchtungssystem nach einem der Ansprüche 1 bis 3,
**dadurch gekennzeichnet, dass**
die anamorphotische Wirkung derart gewählt wird, dass die tangentialen sekundären Lichtquellen (7, 9) in der Bildebene (3) zum Liegen kommen.

6. Beleuchtungssystem nach einem der Ansprüche 1 bis 5,
**dadurch gekennzeichnet, dass**
der Spiegel oder die Linse mit den zweidimensional angeordneten Rasterelementen in Zeilen gegliedert ist, wobei die Zeilen mehrere Rasterelemente umfassen und die Zeilen gegeneinander verschoben sind.

7. Beleuchtungssystem gemäß einem der Ansprüche 1 bis 6,
**dadurch gekennzeichnet, dass**
die optischen Komponenten eine Kollektoreinheit umfassen, wobei die Kollektoreinheit mindestens einen Kollektorspiegel oder eine Kollektorlinse aufweist.

8. Beleuchtungssystem nach Anspruch 7,
**dadurch gekennzeichnet, dass**
die Kollektoreinheit eine anamorphotische Wirkung aufweist.

9. Beleuchtungssystem nach einem der Ansprüche 6 bis 8,
**dadurch gekennzeichnet dass**
die Kollektoreinheit die Lichtquelle in tangentiale und sagittale sekundäre Lichtquellen aufspaltet.

10. Beleuchtungssystem nach einem der Ansprüche 1 bis 9,
**dadurch gekennzeichnet, dass**
die Rasterelemente (24) des ersten Spiegels oder der ersten Linse plan ausgebildet sind.

11. Beleuchtungssystem nach einem der Ansprüche 1 bis 8,
**dadurch gekennzeichnet, dass**
die Rasterelemente des ersten Spiegels zylinderförmig zur Erzeugung einer anamorphotischen Wirkung ausgebildet sind.

12. Beleuchtungssystem nach einem der Ansprüche 1 bis 8,
**dadurch gekennzeichnet, dass**
die Rasterelemente (34) des ersten Spiegels oder der ersten Linse toroidformig zur Erzeugung einer anamorphotischen Wirkung ausgebildet sind.

13. Beleuchtungssystem nach einem der Ansprüche 11 bis 12,
**dadurch gekennzeichnet, dass**
die Rasterelemente (34) mit anamorphotischer Wirkung die Lichtquelle in tangentialen und sagittalen sekundäre Lichtquellen aufspaltet.

**14.** Beleuchtungssystem nach einem der Ansprüche 1 bis 13,
**dadurch gekennzeichnet, dass**
die Rasterelemente (34) des ersten Spiegels oder Linse rechteckige Form aufweisen.

**15.** Beleuchtungssystem nach einem der Ansprüche 1 bis 14,
**dadurch gekennzeichnet, dass**
das Aspektverhältnis des auszuleuchtenden Feldes größer als 2:1, insbesondere 13:1, vorzugsweise 17,5:1, ist.

**16.** Beleuchtungssystem gemäß Anspruch 15,
**dadurch gekennzeichnet, dass**
die Krümmung der Rasterelemente (34) stets in Richtung der schmalen Feldseite größer als in Richtung der langgestreckten Feldseite ist.

**17.** Beleuchtungssystem nach einem der Ansprüche 15 bis 17,
**dadurch gekennzeichnet, dass**
der Abstand der einzelnen Rasterelemente in Richtung der schmalen Feldseite nicht regelmäßig ist und sicht stetig verringert oder vergrößert.

**18.** Beleuchtungssystem nach einem der Ansprüche 1 bis 17,
**dadurch gekennzeichnet, dass**
die Position der Rasterelemente (34) auf dem ersten Spiegel, der in Rasterelemente gegliedert ist, **dadurch** bestimmt wird, dass sich in einer vorgegebenen Austrittspupille des Beleuchtungssystems eine vorgegebene Verteilung von Bildern der sekundärer Lichtquellen bzw. Teilpupillen ergibt.

**19.** Beleuchtungssystem gemäß Anspruch 18,
**dadurch gekennzeichnet, dass**
die vorgegebene Verteilung von sekundären Lichtquellen in der Austrittspupille ein regelmäßiges Gitter oder mehrere gegeneinander verschobene Gitter umfassen.

**20.** Beleuchtungssystem nach einem der Ansprüche 1 bis 19,
**dadurch gekennzeichnet, dass**
die Reflektivitäten der einzelnen Rasterelemente (34) sich unterscheiden.

**21.** Beleuchtungssystem nach Anspruch 20,
**dadurch gekennzeichnet, dass**
die Reflektivität der einzelnen Rasterelemente so eingestellt wird, dass sich für die Uniformität der Scan-Energie ein homogener Verlauf ergibt.

**22.** Beleuchtungssystem nach Anspruch 20 oder 21,
**dadurch gekennzeichnet, dass**
die Reflektivität der einzelnen Feldwaben so eingestellt wird, dass eine vorgegebene Intensitätsverteilung der einzelnen Teilpupillen in der Austrittspupille erreicht wird.

**23.** Beleuchtungssystem nach einem der Ansprüche 1 bis 22,
**dadurch gekennzeichnet, dass**
das Beleuchtungssystem einen zweiten Spiegel oder Linse umfasst, der in Rasterelemente gegliedert ist.

**24.** Beleuchtungssystem nach Anspruch 23,
**dadurch gekennzeichnet, dass**
die Rasterelemente des zweiten Spiegels oder Linse zylinderformig oder toroidförmig ausgebildet sind.

**25.** Beleuchtungssystem nach Anspruch 24,
**dadurch gekennzeichnet, dass**
die Rasterelemente des zweiten Spiegels oder der zweiten Linse am Ort der oder zwischen sagittalen und tangentialen sekundären Lichtquellen angeordnet sind.

**26.** Beleuchtungssystem nach Anspruch 24,
**dadurch gekennzeichnet, dass**

die Rasterelemente des zweiten Spiegels oder der zweiten Linse zylinderförmig ausgebildet und am Ort der sagittalen sekundären Lichtquellen angeordnet sind.

27. Beleuchtungssystem nach einem der Ansprüche 23 bis 26,
   **dadurch gekennzeichnet, dass**
   jedem Rasterelement des ersten Spiegels oder Linse ein Rasterelement des zweiten Spiegels zugeordnet ist.

28. Beleuchtungssystem nach einem der Ansprüche 23 bis 26,
   **dadurch gekennzeichnet, dass**
   jedem Rasterelement des zweiten Spiegels oder Linse zumindest eine Ausdehnung oder Richtung des Rasterelemente des ersten Spiegels oder Linse in die Bildebene (3) abbilden.

29. Beleuchtungssystem nach einem der Ansprüche 1 bis 28,
   **dadurch gekennzeichnet, dass**
   der bzw. die Feldspiegel oder Feldlinsen (50) der Feldlinsengruppe anamorphotische Wirkung aufweisen.

30. Beleuchtungssystem nach einem der Ansprüche 1 bis 29,
   **dadurch gekennzeichnet, dass**
   der bzw. die Feldlinsen oder Feldspiegel (50) der Feldlinsengruppe die tangentialen und sagittalen sekundären Lichtquellen in die vorgegebene Austrittspupille abbilden.

31. Beleuchtungssystem nach einem der Ansprüche 1 bis 30,
   **dadurch gekennzeichnet, dass**
   das Beleuchtungssystem eine Blendenebene (B) aufweist.

32. Beleuchtungssystem nach Anspruch 31,
   **dadurch gekennzeichnet, dass**
   der Feldspiegel oder die Feldlinse derart ausgebildet ist, dass die Blendenebene (B) in die vorgegebene Austrittspupille des Beleuchtungssystems abgebildet wird.

33. Beleuchtungssystem nach Anspruch 31 oder 32,
   **dadurch gekennzeichnet, dass**
   die Blendenebene (B) am Ort der sagittalen sekundären Lichtquellen liegt.

34. Beleuchtungssystem nach Anspruch 31 oder 32,
   **dadurch gekennzeichnet, dass**
   die Blendenebene (B) am Ort der tangentialen Lichtquellen liegt.

35. Beleuchtungssystem nach Anspruch 31 oder 32,
   **dadurch gekennzeichnet, dass**
   die Blendenebene (B) zwischen dem Ort der sagittalen und der tangentialen Lichtquellen liegt.

36. EUV-Projektionsbelichtungsanlage der Mikrolithographie mit einem Beleuchtungssystem nach einem der Ansprüche 1 bis 35, einer Maske, einem Projektionsobjektiv sowie einem lichtempfindlichen Objekt, insbesondere einem Wafer auf einem Trägersystem.

37. EUV-Projektionsbelichtungsanlage der Mikrolithographie gemäß Anspruch 36,
   ausgeführt als Scanning-System.

38. Verfahren zur Herstellung mikroelektronischer Bauelemente, insbesondere Halbleiterchips mit einer EUV-Projektionsbelichtungsanlage gemäß einem der Ansprüche 36 bis 37.

**Claims**

1. An illumination system, especially for lithography with wavelengths ≤ 193 nm, which illuminates a field with an aspect ratio which is not 1:1, comprising

- a light source (20);
- optical components for transforming the light source into secondary light sources, with
- the optical components having an anamorphic effect in order to
- split up the secondary light sources into tangential and sagittal secondary light sources;
- with
- the optical components comprise at least a first mirror or a first lens which is structured into raster elements, with the raster elements having a two-dimensional arrangement, **characterized in that** the raster elements (34) of the first mirror or lens have an aspect ratio which is smaller than the aspect ratio of the field.

2. An illumination system according to claim 1, **characterized in that** the illumination system comprises a field lens group, comprising at least one field mirror or a field plane (50).

3. An illumination system according to claim 1 or claim 2, **characterized in that** the illumination system comprises an image plane (3) and an exit pupil.

4. An illumination system according to one of the claims 1 to 3, **characterized in that** the anamorphic effect is chosen in such a way that the tangential secondary light sources (7, 9) come to lie between the sagittal secondary light sources and the image plane (3).

5. An illumination system according to one of the claims 1 to 3, **characterized in that** the anamorphic effect is chosen in such a way that the tangential secondary light sources (7, 9) come to lie in the image plane (3).

6. An illumination system according to one of the claims 1 to 5, **characterized in that** the mirror or the lens with the two-dimensionally arranged raster elements is structured into lines, with the lines comprising several raster elements and the lines being displaced with respect to each other.

7. An illumination system according to one of the claims 1 to 6, **characterized in that** the optical components comprise a collector unit, with the collector unit comprising at least one collector mirror or a collector lens.

8. An illumination system according to claim 7, **characterized in that** the collector unit has an anamorphic effect.

9. An illumination system according to one of the claims 6 to 8, **characterized in that** the collector unit splits up the light source into tangential and sagittal secondary light sources.

10. An illumination system according to one of the claims 1 to 9, **characterized in that** the raster elements (24) of the first mirror or the first lens are provided with a planar arrangement.

11. An illumination system according to one of the claims 1 to 8, **characterized in that** the raster elements of the first mirror are arranged cylindrically for generating an anamorphic effect.

12. An illumination system according to one of the claims 1 to 8, **characterized in that** the raster elements (34) of the first mirror or the first lens are arranged in a toroidal manner for generating an anamorphic effect.

13. An illumination system according to one of the claims 11 to 12, **characterized in that** the raster elements (34) with anamorphic effect split up the light source into tangential and sagittal secondary light sources.

14. An illumination system according to one of the claims 1 to 13, **characterized in that** the raster elements (34) of the first mirror or lens have a rectangular shape.

15. An illumination system according to one of the claims 1 to 14, **characterized in that** the aspect ratio of the field to be illuminated is larger than 2:1, especially 13:1, preferably 17.5:1.

16. An illumination system according to claim 15, **characterized in that** the curvature of the raster elements (34) is always higher in the direction of the narrow field side than in the direction of the long stretched-out field side.

17. An illumination system according to one of the claims 15 to 17, **characterized in that** the distance of the individual raster elements is not regular in the direction of the narrow field side and continually decreases or increases.

18. An illumination system according to one of the claims 1 to 17, **characterized in that** the position of the raster elements (34) on the first mirror which is structured into raster elements is determined in such a way that a predetermined distribution of images of the secondary light sources or partial pupils is obtained in a predetermined exit pupil of the illumination system.

19. An illumination system according to claim 18, **characterized in that** the predetermined distribution of secondary light sources in the exit pupil comprise a regular grating or several gratings displaced with respect to each other.

20. An illumination system according to one of the claims 1 to 19, **characterized in that** the reflectivities of the individual raster elements (34) differ from each other.

21. An illumination system according to claim 20, **characterized in that** the reflectivity of the individual raster elements is set in such a way that a homogeneous progress is obtained for the uniformity of the scan energy.

22. An illumination system according to claim 20 or 21, **characterized in that** the reflectivity of the individual field honeycombs is set in such a way that a predetermined intensity distribution of the partial pupils in the exit pupil is achieved.

23. An illumination system according to one of the claims 1 to 22, **characterized in that** the illumination system comprises a second mirror or lens which is structured into raster elements.

24. An illumination system according to claim 23, **characterized in that** the raster elements of the second mirror or lens are provided with a cylindrical or toroidal configuration.

25. An illumination system according to claim 24, **characterized in that** the raster elements of the second mirror or second lens are arranged at the location of or between sagittal and tangential secondary light sources.

26. An illumination system according claim 24, **characterized in that** the raster elements of the second mirror or the second lens are provided with a cylindrical arrangement and are arranged at the location of the sagittal secondary light sources.

27. An illumination system according to one of the claims 23 to 26, **characterized in that** a raster element of the second mirror is assigned to each raster element of the first mirror or lens.

28. An illumination system according to one of the claims 23 to 26, **characterized in that** each raster element or the second mirror or lens project at least one extension or direction of the raster element of the first mirror or lens into the image plane (3).

29. An illumination system according to one of the claims 1 to 28, **characterized in that** the field mirror(s) or field lenses (50) of the field lens group have an anamorphic effect.

30. An illumination system according to one of the claims 1 to 29, **characterized in that** the field lenses or the field mirror(s) (50) of the field lens group project the tangential or sagittal secondary light sources into the predetermined exit pupil.

31. An illumination system according to one of the claims 1 to 30, **characterized in that** the illumination system comprises a diaphragm plane (B).

32. An illumination system according to claim 31, **characterized in that** the field mirror or the field lens is arranged in such a way that the diaphragm plane (B) is projected into the predetermined exit pupil of the illumination system.

33. An illumination system according claim 31 or 32, **characterized in that** the diaphragm plane (B) is situated at the location of the sagittal secondary light sources.

34. An illumination system according claim 31 or 32, **characterized in that** the diaphragm plane (B) is situated at the location of the tangential light sources.

35. An illumination system according claim 31 or 32, **characterized in that** the diaphragm plane (B) is located between the location of the sagittal and the tangential light sources.

36. An EUV projection exposure system of microlithography, comprising an illumination system according to one of the claims 1 to 35, a mask, a projection objective and a light-sensitive object, especially a wafer on a carrier system.

37. An EUV projection exposure system of microlithography according to claim 36, arranged as a scanning system.

38. A method for producing microelectronic components, especially semiconductor chips with an EUV projection exposure system according to one of the claims 36 to 37.

## Revendications

1. Système d'éclairage, en particulier pour la lithographie à des longueurs d'onde ≤ 193 nm, qui éclaire un champ selon un rapport d'aspect différent de 1:1, comprenant :

    - une source lumineuse (20)
    - des composants optiques pour transformer la source lumineuse en sources lumineuses secondaires,
    - lesquels composants optiques ont un effet anamorphique,
    - afin de diviser les sources lumineuses secondaires en sources lumineuses secondaires tangentes et sagittales,
    - dans lequel
    - les composants optiques comprennent au moins un premier miroir ou une première lentille divisés en éléments de grille, lesquels éléments de grille ont une disposition bidimensionnelle,

    **caractérisé en ce que** les éléments de grille (34) du premier miroir ou de la première lentille présentent un rapport d'aspect inférieur au rapport d'aspect du champ.

2. Système d'éclairage selon la revendication 1, **caractérisé en ce que** le système d'éclairage comprenant un groupe de lentilles de champ possède au moins un miroir de champ ou plan de champ (50).

3. Système d'éclairage selon la revendication 1 ou 2, **caractérisé en ce que** le système d'éclairage possède un plan d'image (3) et une pupille de sortie.

4. Système d'éclairage selon l'une des revendications 1 à 3, **caractérisé en ce que** l'effet anamorphique est choisi de telle manière que les sources lumineuses secondaires tangentes (7, 9) se placent entre les sources lumineuses secondaires sagittales et le plan d'image (3).

5. Système d'éclairage selon l'une des revendications 1 à 3, **caractérisé en ce que** l'effet anamorphique est choisi de telle sorte que les sources lumineuses secondaires tangentes (7, 9) se placent dans le plan d'image (3).

6. Système d'éclairage selon l'une des revendications 1 à 5, **caractérisé en ce que** le miroir ou la lentille portant les éléments de grille disposés selon deux dimensions est divisé en lignes, lesquelles lignes comprennent plusieurs éléments de grilles et les lignes étant décalées les unes par rapport aux autres.

7. Système d'éclairage selon l'une des revendications 1 à 6, **caractérisé en ce que** les composants optiques comprennent une unité de collecteur, laquelle unité de collecteur comprend au moins un miroir collecteur ou une lentille collectrice.

8. Système d'éclairage selon la revendication 7, **caractérisé en ce que** l'unité de collecteur a un effet anamorphique.

9. Système d'éclairage selon l'une des revendications 6 à 8, **caractérisé en ce que** l'unité de collecteur divise la source lumineuse en sources lumineuses secondaires tangentes et sagittales.

10. Système d'éclairage selon l'une des revendications 1 à 9, **caractérisé en ce que** les éléments de grille (24) du premier miroir ou de la première lentille sont plans.

11. Système d'éclairage selon l'une des revendications 1 à 8, **caractérisé en ce que** les éléments de grille du premier miroir sont cylindriques en vue de créer un effet anamorphique.

**12.** Système d'éclairage selon l'une des revendications 1 à 8, **caractérisé en ce que** les éléments de grille (34) du premier miroir ou de la première lentille sont toroïdaux en vue de créer un effet anamorphique.

**13.** Système d'éclairage selon l'une des revendications 11 à 12, **caractérisé en ce que** les éléments de grille (34) ayant un effet anamorphique partagent la source lumineuse en sources lumineuses secondaires tangentes et sagittales.

**14.** Système d'éclairage selon l'une des revendications 1 à 13, **caractérisé en ce que** les éléments de grille (34) du premier miroir ou de la première lentille ont une forme rectangulaire.

**15.** Système d'éclairage selon l'une des revendications 1 à 14, **caractérisé en ce que** le rapport d'aspect du champ à éclairer est supérieur à 2:1, de préférence de 13:1, et en particulier de 17,5:1.

**16.** Système d'éclairage selon la revendication 15, **caractérisé en ce que** la courbure des éléments de grille (34) est toujours plus grande dans la direction du côté étroit du champ que dans la direction du grand côté du champ.

**17.** Système d'éclairage selon l'une des revendications 15 à 17, **caractérisé en ce que** la distance entre les différents éléments de grille n'est pas régulière dans le sens du côté étroit du champ et diminue ou augmente de façon constante.

**18.** Système d'éclairage selon l'une des revendications 1 à 17, **caractérisé en ce que** la position des éléments de grille (34) sur le premier miroir organisé en éléments de grille est déterminée par le fait qu'il se crée dans une pupille de sortie prédéterminée du système d'éclairage une distribution prédéterminée d'images des sources lumineuses secondaires ou des pupilles partielles.

**19.** Système d'éclairage selon la revendication 18, **caractérisé en ce que** la distribution prédéterminée des sources lumineuses secondaires dans la pupille de sortie couvre une grille régulière ou plusieurs grilles décalées les unes par rapport aux autres.

**20.** Système d'éclairage selon l'une des revendications 1 à 19, **caractérisé en ce que** le pouvoir réfléchissant des différents éléments de grille (34) est différent.

**21.** Système d'éclairage selon la revendication 20, **caractérisé en ce que** le pouvoir réfléchissant des différents éléments de grille est ajusté de telle sorte que l'on obtienne une évolution homogène pour l'uniformité de l'énergie de balayage.

**22.** Système d'éclairage selon la revendication 20 ou 21, **caractérisé en ce que** le pouvoir réfléchissant des différents alvéoles de champ est ajusté de façon à obtenir une distribution prédéterminée de l'intensité des différentes pupilles partielles dans la pupille de sortie.

**23.** Système d'éclairage selon l'une des revendications 1 à 22, **caractérisé en ce que** le système d'éclairage possède un deuxième miroir ou une deuxième lentille organisé en éléments de grilles.

**24.** Système d'éclairage selon la revendication 23, **caractérisé en ce que** les éléments de grille du deuxième miroir ou de la deuxième grille sont de forme cylindrique ou toroïdale.

**25.** Système d'éclairage selon la revendication 24, **caractérisé en ce que** les éléments de grille du deuxième miroir ou de la deuxième lentille sont disposés à l'emplacement des sources lumineuses secondaires tangentes et sagittales ou entre celles-ci.

**26.** Système d'éclairage selon la revendication 24, **caractérisé en ce que** les éléments de grille du deuxième miroir ou de la deuxième lentille sont de forme cylindrique et sont disposés à l'emplacement des sources lumineuses secondaires sagittales.

**27.** Système d'éclairage selon l'une des revendications 23 à 26, **caractérisé en ce que** chaque élément de grille du premier miroir ou de la première lentille est associé à un élément de grille du deuxième miroir.

**28.** Système d'éclairage selon l'une des revendications 23 à 26, **caractérisé en ce que** chaque élément de grille du deuxième miroir ou de la deuxième lentille décrit au moins une étendue ou une direction de l'élément de grille du premier miroir ou de la première lentille dans le plan d'image (3).

29. Système d'éclairage selon l'une des revendications 1 à 28, **caractérisé en ce que** le ou les miroirs de champ ou lentilles de champ (50) du groupe de lentilles de champ produisent un effet anamorphique.

30. Système d'éclairage selon l'une des revendications 1 à 29, **caractérisé en ce que** la ou les lentilles de champ ou miroirs de champ (50) du groupe de lentilles de champ reproduisent les sources lumineuses secondaires tangentes et sagittales dans la pupille de sortie prédéterminée.

31. Système d'éclairage selon l'une des revendications 1 à 30, **caractérisé en ce que** le système d'éclairage possède un plan de diaphragme (B).

32. Système d'éclairage selon la revendication 31, **caractérisé en ce que** le miroir de champ ou la lentille de champ est conformé de telle sorte que le plan de diaphragme (B) est reproduit dans la pupille de sortie prédéterminée du système d'éclairage.

33. Système d'éclairage selon la revendication 31 ou 32, **caractérisé en ce que** le plan de diaphragme (B) se trouve à l'emplacement des sources lumineuses secondaires sagittales.

34. Système d'éclairage selon la revendication 31 ou 32, **caractérisé en ce que** le plan de diaphragme (B) se trouve à l'emplacement des sources lumineuses secondaires tangentes.

35. Système d'éclairage selon la revendication 31 ou 32, **caractérisé en ce que** le plan de diaphragme (B) se trouve entre l'emplacement des sources lumineuses secondaires sagittales et tangentes.

36. Installation d'éclairage par projection EUV en microlithographie avec un système d'éclairage selon l'une des revendications 1 à 35, un masque, un objectif de projection et un objet photosensible, en particulier une plaquette sur un système de support.

37. Installation d'éclairage par projection EUV en microlithographie selon la revendication 36, réalisée comme un système à balayage.

38. Procédé de fabrication de composants microélectroniques, en particulier de puces de semi-conducteurs, à l'aide d'une installation d'éclairage par projection EUV selon l'une des revendications 36 à 37.

Fig.1

Fig.2

Fig.3

## Fig.4

y–Schnitt

## Fig.5

x–Schnitt

## Fig.6

## Fig.7

## Fig.8

EP 1 067 437 B1

Fig.9

## Fig.10

Fig.11

30

INTENSITÄT

x

y

EP 1 067 437 B1

Fig.12

Fig.13

Fig.14

22

20

28

31

7

3

Fig.15

30

Fig.16

Fig.17

Fig.18

3

50

50

NA = 0.0025

7

52

54

23

250.00 MM

EP 1 067 437 B1

Fig.19

Fig.20

Fig.21

EP 1 067 437 B1

Fig.22

Fig.23

EP 1 067 437 B1

Fig.24

34

22

3

50

102

250.00 MM

EP 1 067 437 B1

Fig.25

250.00 MM

EP 1 067 437 B1

## Fig.26

EP 1 067 437 B1

Fig.27

Intensitätsverlauf in Scanrichtung
Zylinderwaben–WaKo mit Feldlinse

## Fig.28

Integrale Scanenergie in der Retikelebene
Zylinderwaben–WaKo mit Feldlinse

Fig.29

Fig.30

Fig.31

## Fig.33

## Fig.32

Fig.34

Fig.35

30

Fig.36